(19) Europäisches Patentamt
European Patent Office
Office européen des brevets

(11) EP 0 442 097 B1

(12) EUROPÄISCHE PATENTSCHRIFT

(45) Veröffentlichungstag und Bekanntmachung des Hinweises auf die Patenterteilung:
**09.10.1996 Patentblatt 1996/41**

(51) Int Cl.[6]: **C08G 77/52**, C08G 77/48, C08G 77/38, C09K 19/40, G03F 7/075

(21) Anmeldenummer: **90124497.0**

(22) Anmeldetag: **18.12.1990**

# (54) Poly (arylenvinylen-siloxane)

Poly(arylenevinylene siloxanes)

Poly(siloxanes arylène-vinyléniques)

(84) Benannte Vertragsstaaten:
**BE CH DE FR GB IT LI NL**

(30) Priorität: **16.02.1990 DE 4004944**

(43) Veröffentlichungstag der Anmeldung:
**21.08.1991 Patentblatt 1991/34**

(73) Patentinhaber: **Consortium für elektrochemische Industrie GmbH**
**D-81379 München (DE)**

(72) Erfinder:
- **Funk, Enno, Dr.**
  **W-8000 München 71 (DE)**
- **Kreuzer, Franz-Heinrich, Dr.**
  **W-8033 Martinsried (DE)**
- **Gramshammer, Cornelia**
  **W-8011 Pöring (DE)**
- **Lottner, Willibald**
  **W-8132 Tutzing (DE)**

(56) Entgegenhaltungen:
**EP-A- 0 157 481** **EP-A- 0 260 786**
**GB-A- 2 196 975** **US-A- 3 051 684**

- **JOURNAL OF POLYMER SCIENCE, Part A, Band 26, Nr. 5, Mai 1988 VIRGIL PERCEC et al. "Synthesis and Characterization of Liquid Crystalline copolymethacrylates, and Copolysiloxanes Containing 4-Methoxy-Hydroxy-Alpha-Methylstilbene Constitutional Isomers as Side-Groups" Seiten 2047-2076**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 442 097 B1

Printed by Jouve, 75001 PARIS (FR)

## Beschreibung

Die Erfindung betrifft Poly(arylenvinylen-siloxane), Verfahren zu ihrer Herstellung sowie deren Verwendung. Der Begriff Poly(arylenvinylen-siloxan) soll der Einfachheit halber auch die Polymere umfassen, die als Silicium-funktionelle Einheit Silane oder Silcarbane enthalten.

Organopolysiloxane sind von großem Interesse, da sie eine hohe thermooxidative Beständigkeit und extreme Kälteflexibilität sowie eine geringe Temperaturabhängigkeit ihrer physikalischen Konstanten aufweisen. In ihren mechanischen Eigenschaften, wie der Zug-, Weiterreiß- und Abziehfestigkeit sind sie meist jedoch organischen Polymeren unterlegen. Um diesen Nachteil zu vermeiden, wurden Versuche unternommen, Organopolysiloxane mit organischen Verbindungen zu modifizieren. Bei den organischen Verbindungen handelt es sich dabei insbesondere um solche Verbindungen, die aromatische oder heterozyklische Strukturelemente enthalten oder über funktionelle Gruppen, wie Ester- und Amidreste verfügen. Hierzu sei beispielsweise auf DE-PS 14 45 357 (R.L. Merker, Dow Corning Corp.; ausgegeben am 6. Februar 1969) und R.L. Merker, M.J. Scott, G.G. Haberland, J. Polym. Sci.: Part A 2 (1964) 31 verwiesen, wo Dimethylsiloxan-Phenylen-Copolymere beschrieben werden. Copolymere aus Siloxan- und aliphatischen sowie aromatischen Kohlenwasserstoffblöcken sind aus US-PS 3,051,684 (H. Morten und A. Rembaum, The Board of Directors of The University of Akron; ausgegeben am 28. August 1962) und US-PS 3,483,270 (E. E. Bostick, General Electric Co; ausgegeben am 9. Dezember 1969) bekannt, während Siloxancopolymere mit aromatischen Ester- und Amidgruppen in DE-PS 25 43 919 (M. Bargain, Rhone-Poulenc Ind.; ausgegeben am 27. Mai 1987 bzw. den entsprechenden US-PS 4,088,670 (ausgegeben am 9. Mai 1987), US-PS 4,147,711 (ausgegeben am 3. April 1979), US-PS 4,213,914 (ausgegeben am 23. Juli 1980) und US-PS 4,275,184 (ausgegeben am 23. Juni 1981) offenbart sind. Beispielhaft für Poly(imid-siloxane) sei hier H. Kuckertz, Makromol. Chem. 98 (1966) 101-8 genannt. Darüber hinaus sind in V. Percec, J. Polym. Sci.: Part A 26 (1988) 2047-76 Siloxanpolymere mit Stilbenen als Seitengruppen beschrieben. Zahlreiche weitere Versuche zur Modifikation von Polysiloxanen mit organischen Verbindungen sind bekannt. Hierzu sei des weiteren M. Wick, G. Kreis und F.-H. Kreuzer in Ullmanns Encyklopädie der technischen Chemie, Verlag Chemie, Weinheim, 4. Aufl., 1982, Bd. 21, Seite 532 ff genannt.

In EP-A 157 481 werden UV-Licht absorbierende Organopolysiloxane beschrieben, die mindestens einen organischen Rest mit einer Vinylenarylengruppierung enthalten.

Es bestand die Aufgabe, thermoplastische Siloxanelastomere bereitzustellen. Diese Aufgabe wird durch die Erfindung gelöst.

Gegenstand der Erfindung sind Poly(arylenvinylen-siloxane), Verfahren zu deren Herstellung sowie deren Verwendung.

Vorzugsweise handelt es sich bei den erfindungsgemäßen Poly(arylenvinylen-siloxanen) um solche aus Einheiten der allgemeinen Formel

$$\left[ (\overset{R}{\underset{R}{Si}}-R^3)_x-\overset{R}{\underset{R}{Si}}-R^2-O_w-(C_6R^1{}_4)-(CH{=}CH-(C_6R^1{}_4)_y)_z-CH{=}CH- (C_6R^1{}_4)-O_w-R^2 \right]_n \qquad (I)$$

worin

R gleich oder verschieden sein kann und einwertige, gegebenenfalls substituierte, von aliphatischer Mehrfachbindung freie, SiC-gebundene organische Reste bedeutet,

$R^1$ gleich oder verschieden sein kann und Wasserstoffatom, Halogenatom, Nitrogruppe, Cyanogruppe oder einwertige, von aliphatischer Mehrfachbindung freie organische Reste, die gegebenenfalls substituiert sein können, bedeutet,

$R^2$ gleich oder verschieden sein kann und zweiwertige, gegebenenfalls substituierte organische Reste bedeutet,

$R^3$ gleich oder verschieden sein kann und Sauerstoffatom oder zweiwertige, gegebenenfalls substituierte, von aliphatischer Mehrfachbindung freie SiC-gebundene organische Reste bedeutet,
n eine Zahl von 2 bis 500, bevorzugt 10 bis 100,
w 0 oder 1, bevorzugt 1,
x eine Zahl von 1 bis 100, bevorzugt 2 bis 50, besonders bevorzugt 3 bis 20,
y 1 oder 2 und
z eine Zahl von 1 bis 3, bevorzugt 1,

bedeutet, mit der Maßgabe, daß y gleich 1 ist, wenn z größer als 1 ist.

Bevorzugt als Reste R sind-Kohlenwasserstoffreste mit 1 bis 12 Kohlenstoffatomen, die gegebenenfalls durch Halogenatome, Ethergruppen, Estergruppen, Epoxygruppen oder Cyanogruppen substituiert sind.

Beispiele für Kohlenwasserstoffreste R sind Alkylreste, wie der Methyl-, Ethyl-, n-Propyl-, iso-Propyl-, 1-n-Butyl, 2-n-Butyl-, iso-Butyl-, tert.-Butyl-, n-Pentyl-, iso-Pentyl-, neo-Pentyl-, tert.-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest; Cycloalkylreste, wie Cyclopentyl-, Cyclohexyl-, Cycloheptylreste und Methylcyclohexylreste; Arylreste, wie der Phenyl- und der Naphthylrest; Alkarylreste, wie o-, m-, p-Tolylreste, Xylylreste und Ethylphenylreste und Aralkylreste, wie der Benzylrest, der $\alpha$- und der $\beta$-Phenylethylrest.

Beispiele für substituierte Kohlenwasserstoffreste R sind Cyanalkylreste, wie der $\beta$-Cyanethylrest, und halogenierte Kohlenwasserstoffreste, beispielsweise Halogenalkylreste, wie der 3,3,3-Trifluor-n-propylrest, der 2,2,2,2',2',2'-Hexafluorisopropylrest, der Heptafluorisopropylrest, und Halogenarylreste, wie der o-, m-, und p-Chlorphenylrest.

Besonders bevorzugt als Reste R sind der Methyl-, Ethyl-3,3,3-Trifluor-n-propyl- und der Phenylrest.

Bevorzugt als Reste $R^1$ sind Wasserstoffatom, Halogenatom, Nitrogruppe, Cyanogruppe, Alkoxy-, Alkoxycarbonyl- sowie Acyloxygruppen und Kohlenwasserstoffreste mit 1 bis 12 Kohlenstoffatomen, die gegebenenfalls mit Halogenatomen substituiert sein können.

Beispiele für Rest $R^1$ sind die als Beispiele für Rest R oben genannten Reste sowie Alkoxygruppen, wie Methoxy-, Ethoxy- oder n-Propyloxygruppen, Alkoxycarbonylgruppen, wie Methoxycarbonyl-, Ethoxycarbonyl- oder n-Propyloxycarbonylgruppen, und Acyloxygruppen, wie Acetoxy- oder Benzoyloxygruppen.

Besonders bevorzugt als Reste $R^1$ sind Wasserstoffatom, Methyl-, Phenyl-, Methoxy-, Methoxycarbonyl-, Acetoxy- und Benzoyloxygruppen sowie Fluor und Chlor.

Bevorzugt als Reste $R^2$ sind zweiwertige, gegebenenfalls substituierte Kohlenwasserstoffreste mit 1 bis 20 Kohlenstoffatomen, die durch Ethersauerstoffatome substituiert sein können.

Beispiele für Reste $R^2$ sind Alkylenreste, wie der Methylen-, Ethylen-, n-Propylen-, iso-Propylen-, 1-n-Butylen-, 2-n-Butylen-, iso-Butylen-, tert.-Butylen-, n-Pentylen-, iso-Pentylen-, neo-Pentylen-, tert.-Pentylenrest, Hexylenreste, wie der n-Hexylenrest, Heptylenreste, wie der n-Heptylenrest, Octylenreste, wie der n-Octylenrest und iso-Octylenreste, wie der 2,2,4-Trimethylpentylenrest, Nonylenreste, wie der n-Nonylenrest, Decylenreste, wie der n-Decylenrest, Dodecylenreste, wie der n-Dodecylenrest, Octadecylenreste, wie der n-Octadecylenrest; Cycloalkylenreste, wie Cyclopentylen-, Cyclohexylen-, Cycloheptylenreste und Methylcyclohexylenreste.

Beispiele für substituierte Reste $R^2$ sind Cyanalkylenreste, wie der $\beta$-Cyanethylenrest, und halogenierte Kohlenwasserstoffreste, beispielsweise Halogenalkylenreste, wie der 3,3,3-Trifluor-n-propylenrest, der 2,2,2,2',2',2'-Hexafluorisopropylenrest, und Halogenarylenreste, wie der o-, m-, und p-Chlorphenylenrest.

Besonders bevorzugt als Reste $R^2$ sind lineare Alkylenreste mit 2 bis 6 Kohlenstoffatomen, insbesondere der Propylen- und Butylenrest.

Bei den Resten $R^3$ handelt es sich besonders bevorzugt um Sauerstoffatom.

Handelt es sich bei dem Rest $R^3$ aber um zweiwertige SiC-gebundene Reste, dann sind Kohlenwasserstoffreste mit 1 bis 30 Kohlenstoffatom(en), die durch Ethersauerstoffatome substituiert sein können, wie beispielsweise Oligooxymethylen- oder Oligooxyethylengruppen, bevorzugt.

Die in den erfindungsgemäßen Poly(arylenvinylen-siloxanen) enthaltenen Vinylengruppen können die cis- oder trans-Konfiguration besitzen, wobei Poly(arylenvinylen-siloxane) mit trans-konfigurierten Vinylengruppen bevorzugt sind.

Die Arylengruppen -($C_6R^1_4$)- können in den erfindungsgemäßen Poly(arylenvinylen-siloxanen) mit den Vinylengruppen bzw. den -$O_w$-$R^2$-Gruppen, wobei $R^1$, $R^2$ und w die jeweils oben dafür angegebene Bedeutung haben, relativ zu der mit der jeweiligen Arylengruppe noch verknüpften Vinylen- bzw. Arylengruppe, in den 1,2-(ortho-), 1,3-(meta-) oder 1,4-(para-) Positionen verknüpft sein, wobei die Verknüpfung über die 1,4-Positionen bevorzugt ist.

Bei den erfindungsgemäßen Poly(arylenvinylen-siloxanen) können die wiederkehrenden Arylenvinylen-siloxaneinheiten gemäß Formel (I) gleich oder verschieden sein.

Obwohl in Formel (I) nicht angegeben, können bis zu 20 Prozent der Diorganosiloxaneinheiten durch $R_3SiO_{1/2}$-, $RSiO_{3/2}$- und $SiO_{4/2}$-Einheiten ersetzt sein, wobei R die vorstehend dafür angegebene Bedeutung hat.

Obwohl in Formel (I) nicht angegeben, können bis zu 50 Prozent der Wasserstoffatome der Vinylengruppen durch Alkylgruppen, insbesondere durch Methylgruppen, ersetzt sein.

Die erfindungsgemäßen Poly(arylenvinylen-siloxane) lassen sich nach an sich bekannten Verfahren herstellen. Vorzugsweise werden die erfindungsgemäßen Poly(arylenvinylen-siloxane) durch Umsetzung von α,ω-Dialkenylarylenvinylen mit zwei Si-gebundene Wasserstoffatome aufweisender Organosiliciumverbindung in Gegenwart eines die Anlagerung von Si-gebundenem Wasserstoff an aliphatische Mehrfachbindung fördernden Katalysators hergestellt.

Bei den im erfindungsgemäßen Verfahren eingesetzten a,w-Di-alkenylarylenvinylenen handelt es sich vorzugsweise um solche der Formel

$$R^4\text{-}O_w\text{-}(C_6R^1{}_4)\text{-}(CH{=}CH\text{-}(C_6R^1{}_4)_y)_z\text{-}CH{=}CH\text{-}(C_6R^1{}_4)\text{-}O_w\text{-}R^4, \qquad (II)$$

wobei

$R^1$, w, y und z eine der obengenannten Bedeutungen haben und $R^4$ gleich oder verschieden sein kann und einen einwertigen, gegebenenfalls substituierten organischen Rest mit endständiger Kohlenstoff-Kohlenstoff-Doppelbindung bedeutet, mit der Maßgabe, daß y gleich 1 ist, wenn z größer als 1 ist.

Bevorzugt sind als Rest $R^4$ einwertige, gegebenenfalls substituierte Kohlenwasserstoffreste mit 1 bis 20 Kohlenstoffatomen, die eine endständige aliphatische Kohlenstoff-Kohlenstoff-Doppelbindung aufweisen.

Beispiele für Rest $R^4$ sind der Vinylrest, Allylrest, n-But-3-enylrest, n-Hex-5-enylrest, n-Undec-10-enylrest und der n-Undec-10-enoylrest.

Obwohl in Formel (II) nicht angegeben, können bis zu 50 Prozent der Wasserstoffatome der Vinylengruppen durch Alkylgruppen, vorzugsweise durch Methylgruppen, ersetzt sein.

Beispiele für die im erfindungsgemäßen Verfahren eingesetzten α,ω-Dialkenylarylenvinylene sind

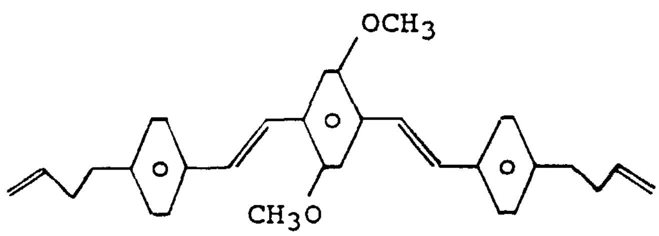

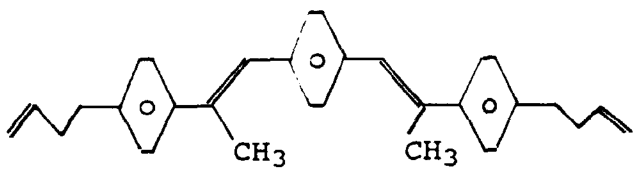

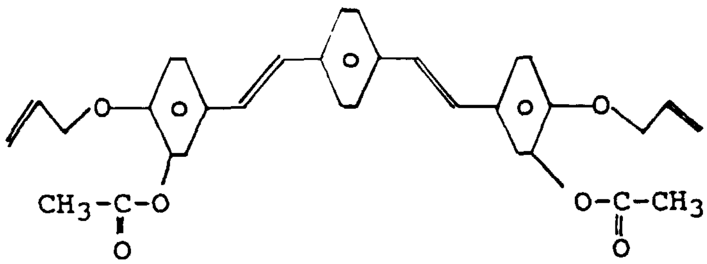

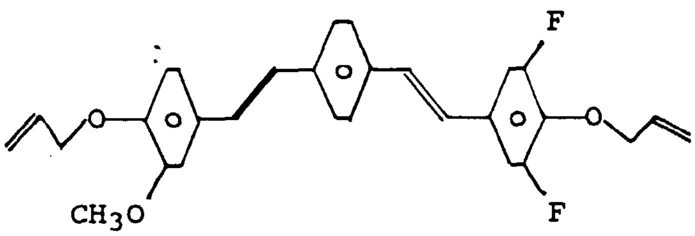

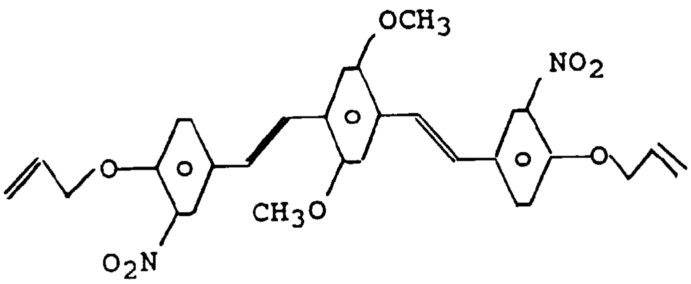

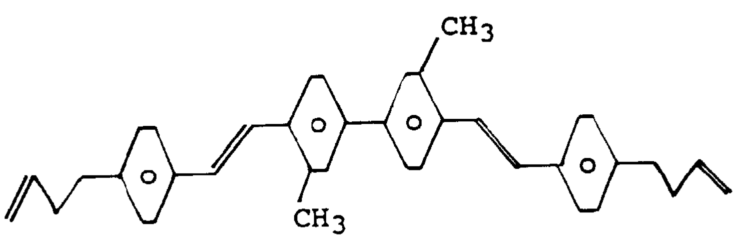

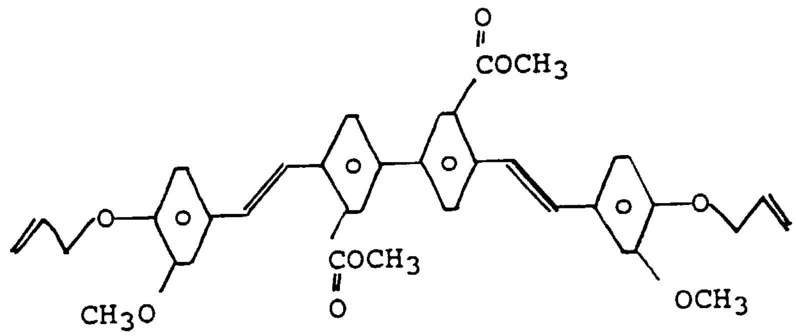

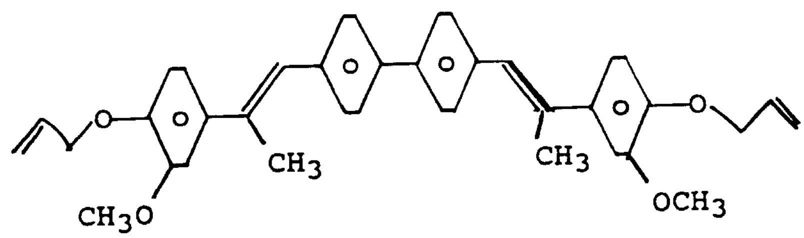

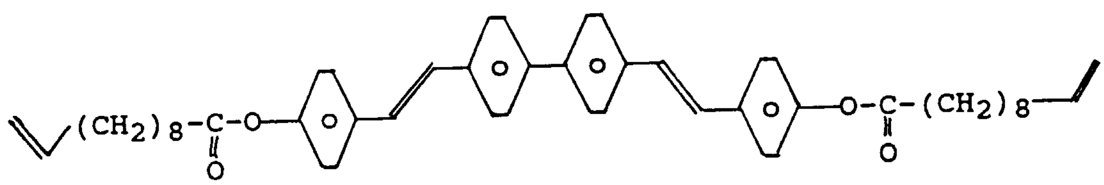

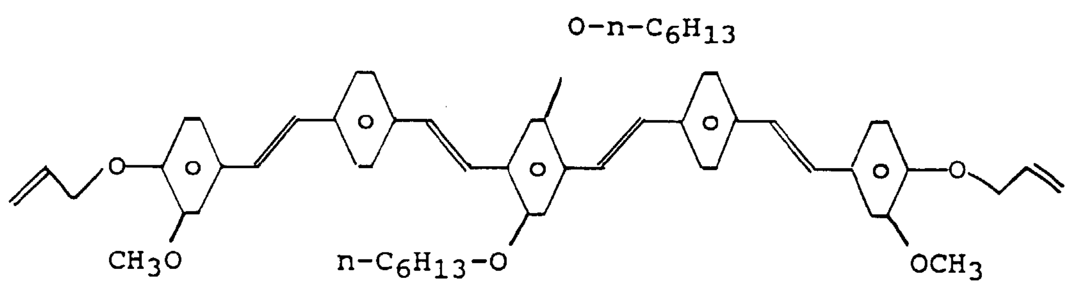

Bei dem erfindungsgemäß eingesetzten α,ω-Dialkenylarylenvinylen kann es sich um eine einzelne Art von α,ω-Dialkenylarylenvinylen handeln. Es kann sich aber auch um ein Gemisch aus mindestens zwei verschiedenen Arten derartiger α,ω-Dialkenylarylenvinylene handeln.

Die im erfindungsgemäßen Verfahren eingesetzten α,ω-Dialkenylarylenvinylene können nach an sich bekannten Verfahren hergestellt werden. Beispielsweise können α,ω-Dialkenylarylenvinylene gemäß Formel (II) durch Umsetzung von Phosphonaten, wie beispielsweise solchen der Formel

$$(R^5O)_2\overset{\overset{\displaystyle O}{\|}}{P}-CH_2-(C_6R^1{}_4)_s-(CH{=}CH-(C_6R^1{}_4))_t-CH_2-\overset{\overset{\displaystyle O}{\|}}{P}(OR^5)_2 \qquad (III)$$

worin

$R^1$ eine der oben angegebenen Bedeutung hat,
$R^5$ gleich oder verschieden sein kann und einen Alkylrest mit 1 bis 10 Kohlenstoffatomen, insbesondere Ethylrest, bedeutet,
s 1 oder 2 und
t 0,1 oder 2 ist,

mit der Maßgabe, daß s gleich 1 ist, wenn t größer 0 ist, mit aromatischen Aldehyden, wie beispielsweise solchen der Formel

$$R^4\text{-}O_w\text{-}(C_6R^1{}_4)\text{-}CHO \qquad (IV)$$

worin
$R^1$, $R^4$ und w eine der oben angegebenen Bedeutungen hat,
in Anwesenheit einer Base, wie beispielsweise Kaliumcarbonat, Kaliumhydroxid, Natriumhydroxid, Natriumhydrid, Natriummethylat, Kalium-tert.-butylat oder Lithiumdiisopropylamid, sowie gegebenenfalls in Anwesenheit eines Katalysators, hergestellt werden.

In dieser dem Fachmann als Wittig-Horner-Emmons-Reaktion bekannten Umsetzung von Phosphonaten mit Aldehyden werden die Eduktmoleküle unter Bildung einer Kohlenstoff-Kohlenstoff-Doppelbindung verknüpft, wobei nahezu ausschließlich transkonfigurierte Doppelbindungen erhalten werden.

Vorteilhafterweise wird die Umsetzung von Phosphonat mit Aldehyd zur Herstellung des im erfindungsgemäßen Verfahren eingesetzten $\alpha,\omega$-Dialkenylarylenvinylens in einem in Bezug auf die Reaktionteilnehmer inerten Lösungsmittel, wie beispielsweise aromatische Kohlenwasserstoffe, wie Benzol, Toluol, Xylol und Ethylbenzol, Phenolether, wie Anisol und 1,2-Dimethoxybenzol, aliphatische Ether, wie Diethylether, tert.-Butylmethylether, 1,2-Dimethoxyethan, Tetrahydrofuran, Dioxan, oder Carbonsäureamide, wie N,H-Dimethylformamid, N,N-Dimethylacetamid oder N-Methylpyrrolidon durchgeführt, wobei Toluol, Anisol und Tetrahydrofuran bevorzugt sind.

Vorzugsweise werden bei der Umsetzung von Phosphonat mit Aldehyd zur Herstellung des im erfindungsgemäßen Verfahren eingesetzten $\alpha,\omega$-Dialkenylarylenvinylens pro Mol Phosphonat zwei Mol Aldehyd sowie zwei Mol Base eingesetzt, wobei im Fall von Kaliumcarbonat als Base bevorzugt 3 Mol eingesetzt werden.

Vorzugsweise wird die Umsetzung von Phosphonat mit Aldehyd bei einer Temperatur zwischen -10 und 160°C und bei einem Druck von 900 bis 3000 hPa durchgeführt.

Besonders bevorzugt wird die Umsetzung von Phosphonat gemäß Formel (III) und Aldehyd gemäß Formel (IV) mit Kaliumcarbonat, Kaliumhydroxid oder Kalium-tert.-butylat als Base, Toluol oder Anisol als Lösungsmittel und 18-Krone-6 sowie Kaliumiodid als Katalysator durchgeführt.

Beispiele für Phosphonate gemäß Formel (III) sind

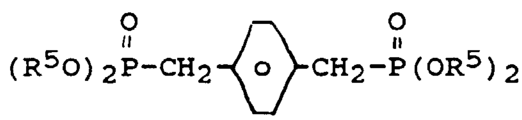

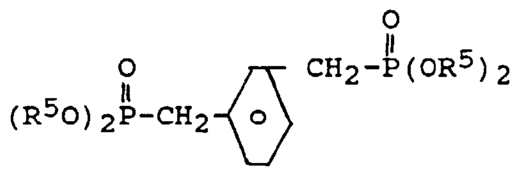

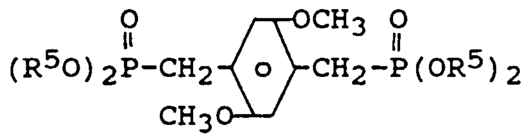

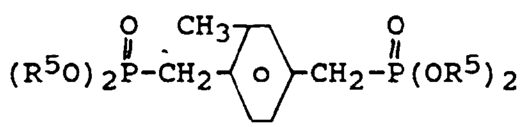

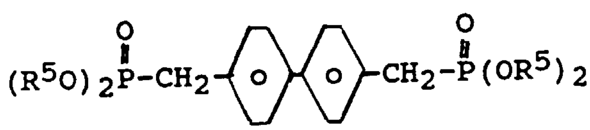

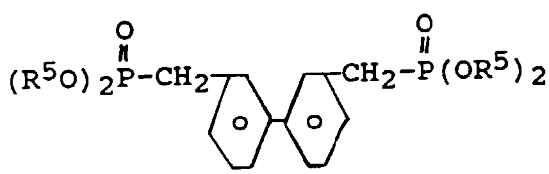

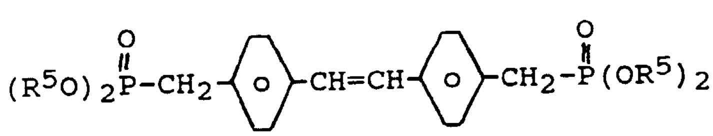

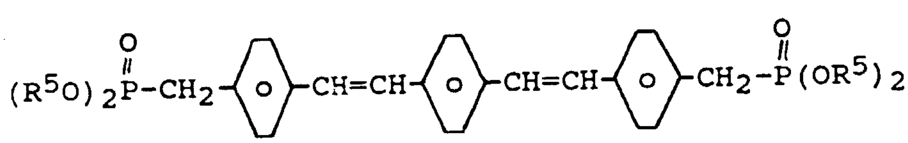 ,

wobei $R^5$ eine der oben angegebenen Bedeutung hat.

Bevorzugt werden zur Herstellung des im erfindungsgemäßen Verfahren eingesetzten α,ω-Dialkenylarylenviny-

lens als Phosphonat

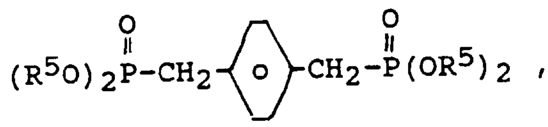

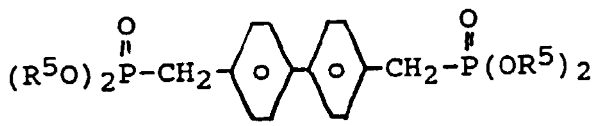

und

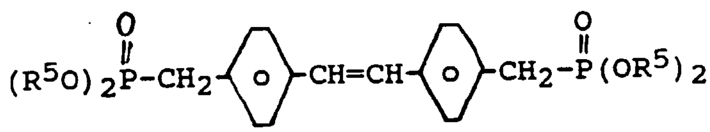

eingesetzt, wobei $R^5$ eine der oben dafür angegebenen Bedeutung hat.

Die zur Herstellung des im erfindungsgemäßen Verfahren eingesetzten α,ω-Dialkenylarylenvinylens verwendeten Phosphonate gemäß Formel (III) können nach an sich bekannten Verfahren hergestellt werden. Hierzu sei beispielsweise auf US-PS 4,371,475 (Showa Kagaku Kogyo, ausgegeben am 1. Februar 1983), US-PS 4,108,887 (Sandoz AG, ausgegeben am 22. August 1978) und GB-OS 1 247 934 (K. Weber; Ciba Ltd.) verwiesen.

Vorzugsweise werden die Phosphonate gemäß Formel (III) aus den entsprechenden Brom- bzw. Chlorverbindungen durch Umsetzung mit Trialkylphosphit hergestellt, wobei sowohl Trialkylphosphit als auch die obengenannten Brom- bzw. Chlorverbindungen käuflich erhältlich bzw. nach in der organischen Chemie gängigen Methoden herstellbar sind.

Bevorzugt wird zur Herstellung des im erfindungsgemäßen Verfahren eingesetzten α,ω-Dialkenylarylenvinylens als Aldehyd solche der Formel

$$CH_2{=}CH\text{-}(CH_2)_v\text{-}O_w\text{-}(C_6R^1{}_4)\text{-}CHO \qquad (V)$$

verwendet, wobei
w und $R^1$ die oben dafür angegebene Bedeutung haben und v eine ganze Zahl von 0 bis 4 ist.

Beispiele für Aldehyde gemäß Formel (V) sind

4-Allyloxybenzaldehyd,
4-Allyloxy-3-methoxy-benzaldehyd,
4-(3-Butenyl)-benzaldehyd und
4-(10-Undecenoyloxy)-benzaldehyd,

wobei 4-Allyloxy-3-methoxy-benzaldehyd und 4-(3-Butenyl)benzaldehyd besonders bevorzugt sind.

Die zur Herstellung des im erfindungsgemäßen Verfahren eingesetzten α,ω-Dialkenylarylenvinylens verwendeten Aldehyde lassen sich nach an sich bekannten Verfahren, wie beispielsweise Veretherung von p-Hydroxybenzaldehyd mit entsprechenden Alkenylhalogeniden oder -tosylaten, herstellen. Hierzu sei beispielsweise auf H. Meerwein in Houben-Weyl, "Methoden der Organischen Chemie", Georg Thieme Verlag, Stuttgart, 4. Auflage, Bd. VI/3, 1965, Seite 49-84, verwiesen.

Beispielsweise werden Aldehyde gemäß Formel (V) durch Grignard-Reaktion von 4-Alkenyl-1-chlorbenzol, welches aus dem entsprechencen Alkenylmagnesiumchlorid und 4-Chlorbenzylchlorid erhalten wird, mit N,N-Dimethylformamid hergestellt.

Selbstverständlich eignen sich auch andere Reaktionen zur Herstellung des im erfindungsgemäßen Verfahren eingesetzten $\alpha,\omega$-Dialkenylarylenvinylens. Beispielsweise kommen statt der oben beschriebenen Umsetzung von Phosphonat und Aldehyd auch die Wittig-Reaktion von Phosphanalkylenen mit Aldehyden, oder etwa Reaktionen von Grignard-Reagenzien mit Aldehyden und anschließender Dehydratisierung der entstandenen Alkohole, oder etwa die als Heck-Reaktion bekannte, palladiumkatalysierte Reaktion von Vinylaromaten mit Halogenaromaten in Frage.

Beispielsweise können die im erfindungsgemäßen Verfahren eingesetzten Arylenvinylene gemäß Formel (II) auch durch Umsetzung von Phosphonaten gemäß der Formel

$$R^4\text{-}O_w\text{-}(C_6R^1{}_4)\text{-}CH_2\text{-}\overset{O}{\overset{\|}{P}}(OR^5)_2 \qquad \text{(VI)}$$

mit Dialdehyden der Formel

$$CHO\text{-}(C_6R^1{}_4)_s\text{-}(CH{=}CH\text{-}(C_6R^1{}_4))_t\text{-}CHO \qquad \text{(VII)}$$

in Anwesenheit einer Base sowie gegebenenfalls in Anwesenheit eines Katalysators hergestellt werden, wobei $R^1$' $R^4$, $R^5$, s, t und w eine der oben dafür angegebenen Bedeutungen haben, mit der Maßgabe, daß s gleich 1 ist, wenn t größer 0 ist. Die Reaktionsbedingungen dieser Umsetzung können dabei die gleichen sein wie bei der oben beschriebenen Umsetzung von Phosphonat gemäß Formel (III) mit Aldehyd gemäß Formel (IV), mit dem Unterschied, daß pro Mol Aldehyd zwei Mol Phosphonat und zwei Mol Base eingesetzt werden, wobei im Fall von Kaliumcarbonat als Base bevorzugt 3 Mol eingesetzt werden.

Bevorzugt als Phosphonate gemäß Formel (VI) werden

4-Allyloxybenzylphosphonat
4-Allyloxy-3-methoxybenzylphosphonat,
4-Allyloxy-3-methylbenzylphosphonat und
4-But-3-enylbenzylphosphonat.

Die Phosphonate gemäß Formel (VI) können ebenfalls aus den entsprechenden Brom- bzw. Chlorverbindungen mit Trialkylphosphit hergestellt werden, wobei die obengenannten Brom- bzw. Chlorverbindungen sowie Trialkylphosphit käuflich erhältlich bzw. nach in der organischen Chemie gängigen Methoden herstellbar sind.

So kann beispielsweise 4-Butenylbenzylchlorid aus Allylmagnesiumchlorid und 1,4-Bis-(chlormethyl)-benzol hergestellt werden.

Bevorzugte Dialdehyde sind

Terephthaldialdehyd,
4,4'-Biphenyldialdehyd,
4,4'-Stilbendialdehyd und
1,4-Bis-(4-formylstyryl)-benzol.

Die Dialdehyde gemäß Formel (VII) können nach an sich bekannten Verfahren hergestellt werden. Hierzu sei beispielsweise auf EP-OS 229 592 (Ciba-Geigy AG; ausgegeben am 22. Juli 1987) verwiesen.

Monomere Arylenvinylene gemäß Formel (II), insbesondere Distyrylbenzol- und Bistilbenderivate, finden breite Anwendung als Fluoreszenzfarbstoffe, beispielsweise als optische Aufheller in der Textilindustrie, sowie als Laserfarbstoffe.

Bei der im erfindungsgemäßen Verfahren eingesetzten zwei Si-gebundene Wasserstoffatome aufweisenden Organosiliciumverbindung handelt es sich vorzugsweise um solche der Formel

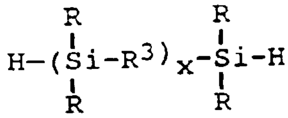 (VIII)

worin
R, $R^3$ und x eine der oben dafür angegebene Bedeutung haben.

Obwohl in Formel (VIII) nicht angegeben, können bis zu 20 Prozent der Diorganosiloxaneinheiten durch $R_3SiO_{1/2}$-, $RSiO_{3/2}$- und $SiO_{4/2}$-Einheiten ersetzt sein, wobei R die vorstehend dafür angegebene Bedeutung hat.

Beispiele für die im erfindungsgemäßen Verfahren eingesetzten zwei Si-gebundene Wasserstoffatome aufweisenden Organosiliciumverbindung sind

$$H\text{-}[Si(CH_3)_2\text{-}O]_4\text{-}Si(CH_3)_2\text{-}H$$

$$H\text{-}[Si(CH_3)_2\text{-}O]_9\text{-}Si(CH_3)_2\text{-}H$$

$$H\text{-}Si(CH_3)_2\text{-}O\text{-}[Si(CH_3)(C_6H_5)\text{-}O]_{15}\text{-}Si(CH_3)_2\text{-}H$$

$$H\text{-}Si(CH_3)_2\text{-}O\text{-}[Si(CH_3)(C_8H_{17})\text{-}O]_{18}\text{-}Si(CH_3)_2\text{-}H$$

$$H\text{-}Si(CH_3)_2\text{-}O\text{-}[Si(C_2H_5)_2\text{-}O]_{10}\text{-}Si(CH_3)_2\text{-}H$$

$$H\text{-}Si(CH_3)_2\text{-}O\text{-}([Si(CH_3)_2\text{-}O][Si(CH_3)(C_6H_5)\text{-}O])_8\text{-}Si(CH_3)_2\text{-}H$$

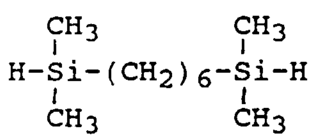

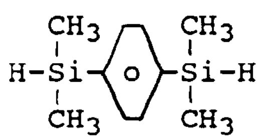

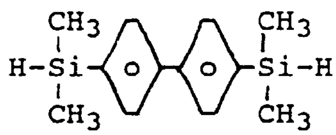 ,

wobei $CH_3$ Methyl-, $C_2H_5$ Ethyl-, $C_6H_5$ Phenyl- und $C_8H_{17}$ Isooctylrest bedeutet.

Die Viskosität der im erfindungsgemäßen Verfahren eingesetzten zwei Si-gebundene Wasserstoffatome aufweisenden Organosiliciumverbindung liegt vorzugsweise zwischen 0,7 und 200 $mm^2/s$, besonders bevorzugt zwischen 1 und 50 $mm^2/s$.

Besonders bevorzugt werden bei dem erfindungsgemäßen Verfahren als Organosiliciumverbindung mit zwei Si-gebundenen Wasserstoffatomen α,ω-Dihydrogendiorgano(poly)siloxane, insbesondere α,ω-Dihydrogendimethyl(poly)siloxane, mit 3 bis 20 Siliciumatomen eingesetzt.

Die erfindungsgemäß eingesetzten Organosiliciumverbindungen mit zwei Si-gebundenen Wasserstoffatomen sind handelsübliche Produkte bzw. nach in der Siliciumchemie gängigen Methoden herstellbar. Hierzu sei zum Beispiel auf W. Noll, "Chemistry and Technology of Silicones", Academic Press, Orlando, 1968, Seite 191 ff und M. Wick, G. Kreis, F.-H. Kreuzer, "Silicone", in "Ullmanns Encyklopädie der technischen Chemie", Verlag Chemie, Weinheim, 4. Aufl., 1982, Bd. 21, Seite 511 ff verwiesen.

Längerkettige α,ω-Dihydrogensiloxane können durch Cohydrolyse von Chlordiorganosiloxanen und Dichlordiorganosiloxanen, durch kationische Polymerisation von Octaorganocyclotetrasiloxanen in Gegenwart von 1,3-Dihydrogentetraalkyldisiloxan oder durch Äquilibrierung von langkettingen OH-terminierten Diorganopolysiloxanen, oder Octaorganocyclotetrasiloxanen, mit 1,3-Dihydrogentetraalkyldisiloxan in Gegenwart saurer Katalysatoren wie $PNCl_2$, oder saurer Ionenaustauscher, wie Amberlyst 15 oder Amberlyst XN-1010 (jeweils wasserfreie Form), hergestellt werden.

Bei der erfindungsgemäß eingesetzten zwei Si-gebundene Wasserstoffatome aufweisenden Organosiliciumverbindung kann es sich um eine einzelne Art von zwei Si-gebundene Wasserstoffatome aufweisender Organosiliciumverbindung handeln. Es kann sich aber auch um ein Gemisch aus mindestens zwei verschiedenen Arten derartiger Organosiliciumverbindungen handeln.

Bei dem erfindungsgemäßen Verfahren liegt das Molverhältnis von α,ω-Dialkenylarylenvinylen zu Organosiliciumverbindung mit zwei Si-gebundenen Wasserstoffatomen in der Reaktionsmasse vorzugsweise zwischen 1:0,7 und 1:1,3, besonders bevorzugt bei 1:1. Weicht das Molverhältnis von α,ω-Dialkenylarylenvinylen zu Organosiliciumverbindung mit zwei Si-gebundenen Wasserstoffatomen deutlich von 1:1 ab, wie beispielsweise 1:0,7 oder 1:1,3, werden sogenannte Präpolymere erhalten, die als Endgruppen jeweils nur die im Überschuß eingesetzte Komponente aufweisen.

Die eingesetzten Katalysatoren können im Rahmen des erfindungsgemäßen Verfahrens die gleichen sein, die auch bisher zum Anlagern von Si-gebundenen Wasserstoffatomen an aliphatische Mehrfachbindungen eingesetzt wurden. Es handelt sich dabei hauptsächlich um Metalle der 8. Nebengruppe und um deren anorganische und organische Verbindungen, wobei Platin und dessen Verbindungen bevorzugt werden.

Beispiele für solche Katalysatoren sind auf einem inerten Träger, wie Aktivkohle, $SiO_2$ oder $Al_2O_3$, abgeschiedenes, feinverteiltes elementares Platin gemäß US-PS 2,970,150 (D.L. Bailey, Union Carbide Corporation; ausgegeben am 31. Januar 1961), Hexachloroplatinsäure gemäß US-PS 2,823,218 (J.L. Speier, Dow Corning Corporation; ausgegeben am 11. Februar 1958) und davon abgeleitete Chloroplatinate, Platinkomplexe des Typs $L{\cdot}PtCl_2$, wobei L ein lineares oder cyclisches Monoolefin, wie Ethen, Propen und Cyclohexen, bedeutet, gemäß US-PS 3,159,601 und US-PS 3,159,662 (Bruce A. Ashby , General Electric Company; jeweils ausgegeben am 1. Dezember 1964), Platinkomplexe des Typs $L{\cdot}PtCl_2$, wobei L ein cyclisches Diolefin, wie 1,5-Cyclooctadien, Norbornadien und Cyclopentadien, bedeutet, gemäß JP-OS 79/76,529 und JP-OS 79/76,530 (Masatoshi Arai, Shin-Etsu Chemical Industry Co., Ltd.; jeweils ausgegeben am 19. Juni 1979) und US-PS 4,276,252 (G. Kreis, Wacker-Chemie GmbH, ausgegeben am 30. Juni 1981) oder ein cyclisches Polyolefin bedeutet gemäß der deutschen Anmeldung mit dem Aktenzeichen P 39 06 514.6 (G. Wenski, Consortium für elektrochemische Industrie GmbH; angemeldet am 1. März 1989), Platinvinylsiloxankomplexe gemäß US-PS 3,814,730 (B.D. Karstedt, General Electric Company; ausgegeben am 4. Juni 1974) und Acetylacetonatkomplexe des Platins gemäß US-PS 4,177,341 (G. Kreis, Consortium für elektrochemische Industrie GmbH; ausgegeben am 4. Dezember 1979).

Bei dem erfindungsgemäßen Verfahren werden wegen deren hohen Wirksamkeit besonders bevorzugt Platinkomplexe des Typs $L{\cdot}PtCl_2$, wobei L ein cyclisches Di- oder Polyolefin bedeutet, insbesondere Dicyclopentadien-Platindichlorid, eingesetzt.

Bei dem erfindungsgemäß eingesetzten Katalysator kann es sich um eine einzelne Art von Katalysator wie auch um ein Gemisch aus mindestens zwei verschiedenen Arten derartiger Katalysatoren handeln.

Die im Rahmen des erfindungsgemäßen Verfahrens eingesetzten Mengen an Katalysator können die gleichen sein wie bei den bisher bekannten Verfahren zum Anlagern von Si-gebundenem Wasserstoff an aliphatische Mehrfachbindung in Gegenwart von Katalysator. Es sind dies vorzugsweise 0,1 bis 1000

Gewichts-ppm, besonders bevorzugt 5 bis 150 Gewichts-ppm, jeweils berechnet als elementares Platin, bezogen auf das Gesamtgewicht der Reaktionsmasse. Bei Platinkomplexen des Typs $L{\cdot}PtCl_2$, wobei L ein cyclisches Di- oder Polyolefin bedeutet, insbesondere Dicyclopentadien-Platindichlorid, als Katalysator sind Konzentrationen zwischen 20 und 100 Gewichts-ppm, berechnet als elementares Platin, bezogen auf das Gesamtgewicht der Reaktionsmasse, völlig ausreichend.

Das erfindungsgemäße Verfahren kann in Anwesenheit oder in Abwesenheit von Lösungsmittel durchgeführt werden, wobei die Bezeichnung Lösungsmittel nicht bedeutet, daß sich alle Reaktionskomponenten in diesen lösen müssen. Die Reaktion kann auch in Emulsion oder Suspension eines oder mehrerer Reaktionspartner durchgeführt werden.

Bei dem erfindungsgemäßen Verfahren ist die Verwendung von in bezug auf die Reaktionsmasse inertem organischen Lösungsmittel, insbesondere von solchem Lösungsmittel, in welchem sich das erfindungsgemäß hergestellte Poly(arylenvinylen-siloxan) mindestens zu einem Teil, bevorzugt vollständig, löst, bevorzugt.

Beispiele für Lösungsmittel sind Alkohole, wie Methanol, Ethanol, n-Propanol, iso-Propanol, n-, sec.- und tert.-Butanol und 2-Butanol; Ester, wie Methylacetat, Ethylacetat, n- und iso-Propylacetat, n-, sec.- und tert.-Butylacetat, Ethylformiat und Diethylcarbonat; Ether, wie Dioxan, Tetrahydrofuran, Diethylether, Di-n-propylether, Diisopropylether, Di-n-butylether, 1,2-Dimethoxybenzol und Anisol; chlorierte Kohlenwasserstoffe, wie Dichlormethan, Trichlormethan, Tetrachlormethan, 1,2-Dichlorethan, 1,1,1-Trichlorethan, Trichlorethylen, Tetrachlorethylen und Chlorbenzol; Kohlenwasserstoffe, wie Pentan, n-Hexan, Hexan-Isomerengemische, Cyclohexan, Heptan, Octan, Waschbenzin, Petrolether, Benzol, Ethylbenzol, Toluol, Xylole und Ketone, wie Aceton, Methylethylketon, Methylisobutylketon, oder Gemische dieser Lösungsmittel, wobei Toluol, Anisol, Chlorbenzol, 4-Methylbenzoesäuremethylester, 3-Chlorbenzoesäuremethylester und Phthalsäuredimethylester, insbesondere Toluol und Anisol, besonders bevorzugt eingesetzt werden.

Bei dem erfindungsgemäßen Verfahren wird Lösungsmittel in Mengen von vorzugsweise 20 bis 99 Gewichtsprozent, besonders bevorzugt 50 bis 95 Gewichtsprozent, jeweils bezogen auf das Gesamtgewicht der Reaktionsmasse, eingesetzt.

Die im Rahmen des erfindungsgemäßen Verfahrens angewandten Temperaturen und Drücke können die gleichen sein wie bei den bisher bekannten Verfahren zum Anlagern von Si-gebundenem Wasserstoff an aliphatische Mehrfachbindung in Gegenwart von Katalysator. Es sind dies vorzugsweise Temperaturen zwischen 0 und 180°C und Drükke zwischen 900 und 1100 hPa, wobei Temperaturen zwischen 80 und 150°C besonders bevorzugt sind. Falls erwünscht, können auch höhere oder niedrigere Drücke angewendet werden.

Bei dem erfindungsgemäßen Verfahren werden $\alpha,\omega$-Dialkenylarylenvinylen, zwei Si-gebundene Wasserstoffatome aufweisende Organosiliciumverbindung, Katalysator und gegebenenfalls Lösungsmittel auf beliebige und an sich bekannte Weise vermischt.

Selbstverständlich kann bei dem erfindungsgemäßen Verfahren zur Herstellung von Poly(arylenvinylen-siloxanen) die Reaktionsmasse außer $\alpha,\omega$-Dialkenylarylenvinylen, Organosiliciumverbindung mit zwei Si-gebundenen Wasserstoffatomen, Katalysator und gegebenenfalls Lösungsmittel noch weitere Stoffe, beispielsweise ausgewählt aus der Gruppe der die Anlagerung von Si-gebundenem Wasserstoff an aliphatische Mehrfachbindung verzögernden Mittel, Kettenbegrenzungsmittel und Vernetzer, enthalten.

Beispiele für die Anlagerung von Si-gebundenem Wasserstoff an aliphatische Mehrfachbindung verzögernde Mittel sind Benzotriazol und 2-Methyl-3-butin-2-ol.

Beispiele für Kettenbegrenzungsmittel sind Verbindungen mit einem Si-gebundenen Wasserstoffatom, wie Trimethyl-, Triethyl- und Diethylmethylsilan, und Verbindungen mit einer aliphatischen Kohlenstoff-Kohlenstoff-Mehrfachbindung, wie Trimethylvinylsilan, Triethylvinylsilan, Styrol, Allylbenzol und N-Allylphthalimid.

Beispiele für Vernetzer sind trifunktionelle Verbindungen, wie Triallylisocyanurat, Glycerintriallylether, 1,3,5-Triallylbenzyltricarboxylat und 1,3,5-Triallylbenzol sowie polyfunktionelle Verbindungen, wie lineare oder cyclische Methylvinyl- bzw. Methylhydrogen(poly)siloxane, die neben den Methylvinyl- bzw. Methylhydrogensiloxaneinheiten auch Dimethylsiloxaneinheiten aufweisen können.

Das erfindungsgemäße Verfahren kann bei kontinuierlichem, semikontinuierlichem und diskontinuierlichem Betrieb durchgeführt werden. Vorzugsweise wird ein Reaktionsteilnehmer, beispielsweise die zwei Si-gebundene Wasserstoffatome aufweisende Organosiliciumverbindung, gegebenenfalls im Gemisch mit Lösungsmittel, einem den anderen Reaktionsteilnehmer enthaltenden Gemisch, wie beispielsweise einem Gemisch aus $\alpha,\omega$-Dialkenylarylenvinylen, Katalysator und gegebenenfalls Lösungsmittel sowie weitere Komponenten, unter Rühren zugetropft.

Nach Beendigung der erfindungsgemäßen Umsetzung von $\alpha,\omega$-Dialkenylarylenvinylen mit zwei Si-gebundene Wasserstoffatome aufweisender Organosiliciumverbindung in Gegenwart eines die Anlagerung von Si-gebundenem Wasserstoff an aliphatische Mehrfachbindung fördernden Katalysators wird die Reaktionsmasse nach an sich bekannten Verfahren, wie beispielsweise Destillation, Filtration und Umfällen, aufgearbeitet. Das erfindungsgemäße Poly(arylenvinylen-siloxan) wird mit einer Ausbeute von im allgemeinen mehr als 70 %, bezogen auf $\alpha,\omega$-Dialkenylarylenvinylen und zwei Si-gebundene Wasserstoffatome aufweisender Organosiliciumverbindung, erhalten.

Die nach dem erfindungsgemäßen Verfahren hergestellten Poly(arylenvinylen-siloxane) weisen vorzugsweise ein durchschnittliches Molekulargewicht (Gewichtsmittel) $M_w$ zwischen 5 000 und 500 000, besonders bevorzugt zwischen 15 000 und 150 000, auf. Der Siloxananteil, das heißt der Gewichtsanteil der Organosiliciumverbindung im erfindungsgemäß hergestellten Poly(arylenvinylen-siloxan), liegt dabei vorzugsweise zwischen 20 und 95 Gewichtsprozent, besonders bevorzugt zwischen 35 und 80 Gewichtsprozent.

Die erfindungesgemäßen Poly(arylenvinylen-siloxane) besitzen eine beständige fluoreszierende Eigenfarbe sowie das Eigenschaftsbild thermoplastischer Elastomere mit sehr guten mechanischen Eigenschaften. Darüberhinaus zeichnen sich die erfindungsgemäßen Poly(arylenvinylen-siloxane) durch eine sehr hohe thermooxidative Beständigkeit aus.

Bis auf wenige Ausnahmen zeigen fast alle Poly(arylenvinylen-siloxane), insbesondere solche mit trans-konfigurierten Vinylengruppen und mit Siloxananteilen von 35 bis 80 Gewichtsprozent, flüssigkristallines Verhalten, wobei sich die Mesophasen der Poly(arylenvinylen-siloxane) im allgemeinen über große Temperaturbereiche erstrecken. Der Klärpunkt sowie der Glaspunkt liegen dabei in der Regel umso niedriger, je höher der Siloxananteil ist.

Für die erfindungsgemäßen Poly(arylenvinylen-siloxane) bestehen zahlreiche Anwendungsmöglichkeiten. So eignen sie sich beispielsweise zur Herstellung von Formmassen nach thermoplastischen Verarbeitungsverfahren, wie Spritzgießen oder Extrudieren.

Der jeweiligen Anwendung entsprechend können dem erfindungsgemäßen Poly(arylenvinylen-siloxan) dabei die üblichen Zusatzstoffe,wie Füllstoffe, Pigmente, Verarbeitungshilfsmittel und Fluoreszenzlöscher, zugesetzt werden. Darüber hinaus können die erfindungsgemäßen Poly(arylenvinylen-siloxane) anderen Polymeren zugesetzt werden, um diesen Fluoreszenzeigenschaften zu verleihen.

Des weiteren können die erfindungsgemäßen Poly(arylenvinylen-siloxane) zu Duromeren vernetzt werden. So lassen sich beispielsweise die erfindungsgemäßen Poly(arylenvinylensiloxane), insbesondere solche gemäß Formel (I) mit $R^1$ gleich Wasserstoffatom und y gleich 1, auf relativ einfache Weise durch photochemische (2+2)-Cycloaddition quervernetzen, wenn im Bereich ihrer Absorptionsbande eingestrahlt wird. Die erhaltenen Duromere sind im allgemeinen farblos transparent und besitzen sehr gute mechanische Eigenschaften.

Die erfindungsgemäßen Poly(arylenvinylen-siloxane) können ferner auf dem Gebiet der optischen Informationsspeicherung und für laseroptische Anwendungen, wie z.B. zur Speicherung von Hologrammen, eingesetzt werden. Darüberhinaus lassen sich die erfindungsgemäßen Poly(arylenvinylen-siloxane) für Photoresistmaterialien mit hohem Auflösungsvermögen verwenden.

In den nachstehend beschriebenen Beispielen beziehen sich alle Angaben von Teilen und Prozentsätzen, falls nicht anders angegeben, auf das Gewicht. Sofern nicht anders angegeben, werden die nachstehenden Beispiele bei einem Druck der umgebenden Atmosphäre, also etwa bei 1000 hPa, und bei Raumtemperatur, also bei etwa 23°C, bzw. bei einer Temperatur, die sich beim Zusammengeben der Reaktanden bei Raumtemperatur ohne zusätzliche Heizung oder Kühlung einstellt, durchgeführt.

Die Bestimmung des mittleren Molekulargewichts $M_W$ und des mittleren Polymerisationsgrades $P_W$ erfolgte gelpermeationschromatographisch relativ zu Polystyrol-Standards mit Hilfe eines Hochdruck-Flüssigkeitschromatographen unter Verwendung von Polystyrolgel-Säulen und Tetrahydrofuran als Laufmittel.

Die Messung der Inhärentviskositäten wurde an einem Ubbelohde-Kapillarviskosimeter bei einer Temperatur von 25°C in Tetrahydrofuran bei Konzentrationen von C = 0,2 g/dl (1 dl = 100 $cm^3$) durchgeführt. Die Inhärentviskosität $\eta_{inh}$ ist definiert durch die Gleichung $\eta_{inh} = \ln \eta_{rel}/C$, wobei die relative Viskosität $\eta_{rel}$ den Quotienten der Laufzeit der Polymerlösung und des reinen Lösungsmittels im Kapillarviskosimeter darstellt.

Thermoanalytische Messungen wurden bei einer Aufheizrate von 10°/min durchgeführt. Der Glaspunkt $T_g$ und Klärpunkt $T_i$ wurden dem 2. Lauf der Differentialthermoanalyse-(DTA-)Kurve entnommen und die Zersetzungstemperatur - 5 % Gewichtsverlust - der Thermogravimetrie-(TG-)Kurve.

Die Bestimmung der Schichtabstände d erfolgte durch Röntgenkleinwinkel-Beugungsexperimente.

Herstellung von α,ω-Dihydrogendimethyl(poly)siloxanen

**A**

1250 ml (6,98 mol) 1,3-Dihydrogentetramethyldisiloxan (käuflich erhältlich unter der Bezeichnung "HSi2" bei der Wacker-Chemie GmbH, D-8000 München) werden in einer 5 l-Enghalsflasche vorgelegt und unter Rühren mit 1875 g α,ω-Dihydroxydimethylpolysiloxan (käuflich erhältlich bei der ABCR GmbH & Co., D-7500 Karlsruhe 21, unter der Bezeichnung "Polydimethylsiloxane, Silanol-Terminated, PS 345.5") portionsweise versetzt. In dieses Gemisch werden 25,1 ml einer $PNCl_2$-Lösung (15 prozentig in $CHCl_3$; käuflich erhältlich bei der Aldrich-Chemie GmbH & Co. KG, D-7924 Steinheim, unter der Bezeichnung "Phosphornitrilchlorid, trimer".) und anschließend weitere 938 g des oben näher bezeichneten α,ω-Dihydroxydimethylpolysiloxans gegeben. Die so erhaltene Mischung läßt man bis zur vollständigen Homogenisierung (ca. 6 Stunden) rühren, wäscht dann mit insgesamt 6 1 Wasser, trocknet über Natriumsulfat und destilliert im Vakuum.

Es werden die folgenden Fraktionen erhalten, wobei der zu dem jeweiligen Siedepunkt (Kp) gehörende Druck in Torr angegeben ist.

1. Fraktion: $Kp_{94}$ 105 - 110°C

205.3 g α,ω-Dihydrogenoctamethyltetrasiloxan (55%) und Octamethylcyclotetrasiloxan (44%)

2. Fraktion: $Kp_{48}$ 120.5 - 123.5°C

110.1 g α,ω-Dihydrogendecamethylpentasiloxan (67%) und Decamethylcyclopentasiloxan (33%)

3. Fraktion: $Kp_{18}$ 100°C

55.0 g α,ω-Dihydrogendecamethylpentasiloxan (73%) und Decamethylcyclopentasiloxan (27%)

4. Fraktion: $Kp_7$ 108.5 - 109.5°C

130.5 g α,ω-Dihydrogendodecamethylhexasiloxan (92.4%) und Dodecamethylcyclohexasiloxan (7.6%)

5. Fraktion: $Kp_7$ 130.5 - 145°C

116 g α,ω-Dihydrogentetradecamethylheptasiloxan (87%) und Tetradecamethylcycloheptasiloxan (13%)

6. Fraktion: $Kp_7$ 145 - 154°C

166 g α,ω-Dihydrogenhexadecamethyloctasiloxan

7. Fraktion: $Kp_7$ 170°C

121 g α,ω-Dihydrogenoctadecamethylnonasiloxan

8. Fraktion: $Kp_{0.01}$ 136 - 139°C

100.5 g α,ω-Dihydrogeneicosamethyldecasiloxan

9. Fraktion: $Kp_{0.01}$ 150°C

113.1 g α,ω-Dihydrogendocosamethylundecasiloxan

10. Fraktion:$Kp_{0.05}$ 163°C

96.7 g α,ω-Dihydrogentetracosamethyldodecasiloxan.

**B**

92,5 g (0,31 mol) Octamethylcyclotetrasiloxan (käuflich erhältlich bei Aldrich-Chemie GmbH & Co. KG, D-7924 Steinheim) und 20,9 g (0,16 mol) 1,3-Dihydrogentetramethyldisiloxan (käuflich erhältlich unter der Bezeichnung "HSi2" bei der Wacker-Chemie GmbH, D-8000 München) werden mit 20 g Ionenaustauscher Amberlyst XN-1010 in der wasserfreien Form (käuflich erhältlich bei Aldrich-Chemie GmbH & Co. KG, D-7924 Steinheim) versetzt und langsam auf 100° C erhitzt. Nach dem Abkühlen wird der Ionenaustauscher abfiltriert.

Das Filtrat besteht aus einem Äquilibrat, aus dem durch Andestillieren bei einer Temperatur von 50°C und einem Druck von 13 hPa niedermolekulare Bestandteile entfernt werden. Der so erhaltene Rückstand (110.7 g) besteht aus einem α,ω-Dihydrogendimethyl(poly)siloxan-Gemisch mit einer mittleren Kettenlänge von 12 Siloxaneinheiten. Dieses α,ω-Dihydrogendimethyl(poly)siloxan-Gemisch kann bei dem erfindungsgemäßen Verfahren direkt eingesetzt werden.

**Beispiel 1**

a) Herstellung von 1-(3-Butenyl) -4-chlormethylbenzol

Zu einer Lösung von 332,6 g (1,90 mol) 1,4-Bis-(chlormethyl)benzol (käuflich erhältlich unter der Bezeichnung α, α'-Dichlor-p-xylol bei Aldrich-Chemie GmbH & Co. KG, D-7924 Steinheim) in 1 000 ml wasserfreiem Tetrahydrofuran wird bei einer Temperatur um 15°C eine Lösung von 1,49 mol Allylmagnesiumchlorid (käuflich erhältlich bei Aldrich Chemie GmbH & Co. KG, D-7924 Steinheim) in 2 000 ml Tetrahydrofuran langsam zugetropft. Nach üblicher Aufarbeitung und Kristallisation von nicht umgesetztem 1,4-Bis-(chlormethyl)-benzol aus Heptan verbleiben 234,2 g eines Produktes, welches nach gaschromatographischen Untersuchungen 83% 1-(3-Butenyl)-4-chlormethylbenzol, 11% 1,4-Bis-(3-butenyl)-benzol sowie noch 6% 1,4-Bis-(chlormethyl)-benzol enthält.

Das so erhaltene 1-(3-Butenyl)-4-chlormethylbenzol zeigt in $CDCl_3$ im 200 MHz-$^1$H-NMR-Spektrum mit TMS als innerem Standard Signale bei 2,35 (dt, J=7; 7Hz, 2H, -$C\underline{H}_2$-CH=$CH_2$), 2,70 (t, J=7Hz, 2H, Ar-$C\underline{H}_2$-$CH_2$-CH=$CH_2$), 4,55

(s, 2H, Ar-$CH_2$-Cl), 4,98 (dd, J=10; 2Hz, 1H, -CH=$CH_a\underline{H}_b$), 5,04 (dd, J=16; 2Hz, 1H, -CH=$C\underline{H}_aH_b$), 5,84 (ddt, J=16; 10; 7Hz, 1H, -C$\underline{H}$=$CH_2$) und 7,24 (AA'BB'-Spektrum; 4H, -Ar-) ppm, wobei Ar Aromat bedeutet.

b) Herstellung von 4-(3-Butenyl)-benzylphosphonsäurediethylester

Zu 294 ml (1,71 mol) Triethylphosphit (käuflich erhältlich unter der Bezeichnung Phosphorigsäuretriaethylester bei Aldrich-Chemie GmbH & Co. KG, D-7924 Steinheim) werden bei einer Temperatur von 90°C langsam 281,4 g (83 %ig entsprechend 1,56 mol) des oben unter a) beschriebenen 1-(3-Butenyl)-4-chlormethylbenzols getropft. Man erhitzt diese Mischung 5 Stunden lang auf eine Temperatur von 150°C und rührt bei dieser Temperatur bis zum Ende der Gasentwicklung. Nach Destillation über eine 15 cm-Vigreux-Kolonne werden als Hauptfrakticn 325,9 g 4-(3-Butenyl)-benzylphosphonsäurediethylester erhalten, was einer Ausbeute von 89 % entspricht. Der Siedepunkt liegt bei einem Druck von 0,01 Torr zwischen 125 und 132°C.

Der so erhaltene 4-(3-Butenyl)-benzylphosphonsäurediethylester zeigt in $CDCl_3$ im 80 MHz-$^1$H-NMR-Spektrum mit TMS als innerem Standard Signale bei 1,23 (t, J=7Hz; 6H, $P(OCH_2\text{-}C\underline{H}_3)_2$), 2,30 (dt, J=6; 7Hz, 2H, $H_2C$=CH-$C\underline{H}_2$-), 2,64 (t, J=7Hz, 2H, Ar-$C\underline{H}_2$-$CH_2$-), 3,08 (d, J=21Hz, 2H, Ar-$CH_2$-P), 3,97 (dq, J=7; 7Hz, 4H, $P(OC\underline{H}_2\text{-}CH_3)_2$), 4,93 (ddt, J=10; 2; 2Hz, 1H, $H_a\underline{H}_b$C=CH-$CH_2$-), 4,96 (ddt, J=16; 2; 2Hz, 1H, $\underline{H}_aH_b$C=CH-$CH_2$-), 5,79 (ddt, J=16; 10; 6Hz, 1H, $H_2C$=C$\underline{H}$-$CH_2$-) und 7,12 (AA'BB'-Spektrum; 4H, -Ar-) ppm, wobei Ar Aromat bedeutet.

c) Herstellung von 1,4-Bis(4-(3-butenyl)-styryl)-benzol

In einem 4 1-Dreihalskolben werden 117,5 g (1,05 mol) Kalium-tert.-butylat (käuflich erhältlich bei Aldrich-Chemie GmbH & Co. KG, D-7924 Steinheim), 2,4 g (15 mmol) Kaliumjodid und 9,8 g (37 mmol) 18-Krone-6 in 1 000 ml Toluol vorgelegt und unter Rühren und unter Kochsalz/Eis-Kühlung eine Lösung von 59,1 g (0,44 mol) Terephthaldialdehyd (käuflich erhältlich bei Aldrich-Chemie GmbH & Co. KG, D-7924 Steinheim) und 249,0 g (0,88 mol) des oben unter b) beschriebenen 4-(3-Butenyl)-benzylphosphonsäurediethylesters in 500 ml Toluol zugetropft. Anschließend läßt man bei Raumtemperatur ca. 8 Stunden weiterrühren. Der entstandene gelbe Niederschlag wird abgesaugt, mit heißem Ethanol gewaschen und im Vakuum getrocknet. Es verbleiben 172,2 g gelber Kristallisats, was einer Ausbeute von 82 % entspricht.

Das so erhaltene 1,4-Bis(4-(3-butenyl)-styryl)-benzol zeigt in $CDCl_3$ im 200 MHz-$^1$H-NMR-Spektrum mit TMS als innerem Standard Signale bei 2,40 (dt, J=7; 7Hz, 4H, 2x $H_2C$=CH-$C\underline{H}_2$-), 2,72 (t, J=7Hz, 4H, 2x Ar-$C\underline{H}_2$-$CH_2$-), 5,00 (ddt, J=10; 2; 2Hz, 2H, 2x $\underline{H}_aH_b$C=CH-$CH_2$-), 5,06 (ddt, J=16; 2Hz, 2H, 2x $\underline{H}_aH_b$C=CH-$CH_2$-), 5,87 (ddt, J=16; 10; 7Hz, 2H, 2x $H_2C$=C$\underline{H}$-$CH_2$-), 7,08 (m, schmal, 4H, -Ar-C$\underline{H}$=C$\underline{H}$-Ar-), 7,31 (AA'BB'-Spektrum; 8H, 2x -$H_2$C-$\underline{Ar}$-CH=) und 7,48 (m, schmal, 4H, 2x =HC-$\underline{Ar}$-CH=) ppm, wobei Ar Aromat bedeutet,
im Infrarotspektrum (KBr-Preßling) signifikante Banden bei 1640 (m), 1520 (m), 1450 (m), 1420 (m), 995 (m), 970 (s), 910 (s) und 550 (s) $cm^{-1}$ sowie
im UV-Spektrum mit $CH_2Cl_2$ als Lösungsmittel
$\lambda_{max}$ (lg ε) = 361 nm (5,68).

d) Herstellung von Dicyclopentadien-Platindichlorid

Dicyclopentadien-Platindichlorid ($dicpPtCl_2$) gemäß US-PS 4,276,252 (G. Kreis, Wacker-Chemie GmbH; ausgegeben am 30. Juni 1981) wird nach literaturbekannten Verfahren (J.Chatt, L.M.Vallarino, L.M.Venanzi, J.Chem.Soc. (London) (1957) 2496-505 und H.C.Clark, L.E.Manzer, J.Organometal.Chem. 59 (1973) 411-28) hergestellt. 7,00 g (0,0169 mol) $K_2PtCl_4$ werden in 120 ml Wasser gelöst und mit 90 ml n-Propanol, 11,50 g (0,0870 mol) Dicyclopentadien sowie 60 mg wasserfeiem $SnCl_2$ versetzt. Der nach zweitägigem Rühren bei Raumtemperatur ausgefallene, voluminöse Niederschlag wird abfiltriert und mit Wasser, wenig Ethanol und anschließend n-Hexan gewaschen. Der Niederschlag wird in Dichlormethan gelöst und anschließend bei einer Temperatur von -80 °C unter Zugabe von n-Hexan gefällt. Nach Filtration und Trocknen verbleiben 5,70 g (0,0143 mol) $dicpPtCl_2$ als helles Pulver, welches laut Elementaranalyse 49,0 Gewichtsprozent Platin enthält. Die Ausbeute, bezogen auf elementares Platin, beträgt 85 %.

15,3 g (39,2 mmol) des oben unter c) beschriebenen 1,4-Bis-(4-(3-butenyl)-styryl)-benzols und 18,3 g (39,2 mmol) des oben unter A beschriebenen α,ω-Dihydrogendodecamethylhexasiloxans werden unter Rühren und unter einer Argon-Atmosphäre in 1 200 ml Toluol auf eine Temperatur von 100°C erhitzt. Anschließend werden 1,54 ml einer $1{,}27\cdot10^{-3}$ molaren Lösung von Dicyclopentadienylplatindichlorid, dessen Herstellung oben unter d) beschrieben ist, in Chloroform zugetropft und dann etwa eine Stunde unter Rückfluß auf 110°C erhitzt. Nach dem Abkühlen wird das so erhaltene Gemisch auf die Hälfte des ursprünglichen Volumens im Vakuum eingeengt. Die verbleibende Lösung wird unter Rühren auf 2,5 l Ethanol gegossen, wobei das erfindungsgemäße Poly(arylenvinylen-siloxan) ausfällt. Der Niederschlag wird abgesaugt und bei einer Temperatur von 70°C und einem Druck von 10 Torr getrocknet. Es verbleiben 25,8 g eines gelbgrünen Pulvers, was einer Ausbeute von 80 % entspricht, mit einem mittleren Molekulargewicht

(Gewichtsmittel) $M_w$ von 25 000, einem Verhältnis von Gewichtsmittel $M_w$ zu numerischem Mittel $M_n$ von 2,38, einem mittleren Polymerisationsgrad $P_w$ von 30 mit folgender Wiederholungseinheit

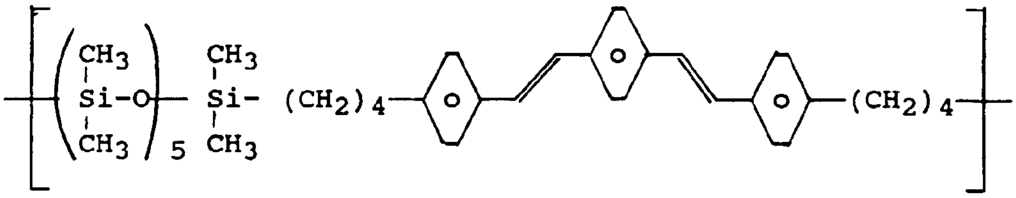

Das erfindungsgemäße Poly(arylenvinylen-siloxan) hat eine Inhärentviskosität von 0,28 dl/g, einen Glaspunkt Tg bei 105°C, eine Zersetzungstemperatur bei 350°C unter Luft und bei 405°C unter Stickstoff und unterhalb des Klärpunktes bei 136°C eine smektisch-C-Schichtstruktur, wobei der Schichtabstand 2,9 nm beträgt.

Das erfindungsgemäße Poly(arylenvinylen-siloxan) zeigt in $CDCl_3$ im 200 MHz-$^1$H-NMR-Spektrum mit TMS als innerem Standard Signale bei 0,04 (s, 12H, -$CH_2$-Si($C\underline{H}_3$)$_2$-O-), 0,08 (2s, 24H, -O-Si($C\underline{H}_3$)$_2$-O-), 0,59 (m, -Si-$CH_2$-), 1,40 (m, 4H, -Si-$CH_2$-$C\underline{H}_2$-), 1,65 (tt, J=7; 7Hz, 4H, -Si-$CH_2$-$CH_2$-$C\underline{H}_2$-), 2,62 (t, J=7Hz, 4H, -$CH_2$-Ar-), 7,09 (s, 4H, -Ar-CH=CH-Ar-CH=CH-Ar-), 7,31 (AA'BB'-Spektrum; 8H, 2x -$CH_2$-$\underline{Ar}$-CH=) und 7,49 (s, 4H, =HC-$\underline{Ar}$-CH=) ppm, wobei Ar Aromat bedeutet,
im Infrarotspektrum (KBr-Preßling) signifikante Banden bei 3020 (w), 2960 (m), 2920 (m), 2855 (w), 2130 (w), 1520 (m), 1420 (m), 1260 (s), 1100-1000 (s), 965 (m), 910 (w), 840 (s), 800 (s), 700 (w) und 545 (m) $cm^{-1}$ sowie im UV-Spektrum mit Tetrahydrofuran als Lösungsmittel
$\lambda_{max}$ (lg ε) = 323 nm (4,48).

**Beispiel 2**

a) Herstellung von Benzol-1,4-bis-(methylenphosphonsäure)-tetraethylester

Zu einer Schmelze von 100 g (0,57 mol) 1,4-Bis-(chlormethyl)-benzol (käuflich erhältlich bei Aldrich-Chemie GmbH & Co. KG, D-7924 Steinheim) werden bei 110°C 205,6 ml Triethylphosphit (käuflich erhältlich bei Aldrich Chemie GmbH & Co. KG, D-7924 Steinheim) getropft. Man läßt noch 14 Stunden bei 130 bis 150°C rühren und gießt die 80 bis 100°C heiße Lösung auf n-Heptan. Die ausgefallenen weißen Kristalle werden abgesaugt und im Vakuum bei 30°C getrocknet. Es verbleiben 205,6 g eines weißen Pulvers, was einer Ausbeute von 95% entspricht.

Der so erhaltene Benzol-1,4-bis-(methylenphosphonsäure)-tetraethylester zeigt in $CDCl_3$ im 200 MHz-$^1$H-NMR-Spektrum mit TMS als innerem Standard Signale bei 1,23 (t, J=7Hz, 12H, 4x -$CH_3$), 3,13 (d, J=20Hz, 4H, 2x Ar-$CH_2$-P), 4,00 (dq, J=7; 7Hz, 8H, 2x P(O$C\underline{H}_2$$CH_3$)$_2$) und 7,25 (s, -Ar-) ppm, wobei Ar Aromat bedeutet.

b) Herstellung von 4-Allyloxy-3-methoxybenzaldehyd

388,2 g (2,0 mol) Vanillin (käuflich erhältlich bei Aldrich-Chemie GmbH & Co. KG, D-7924 Steinheim) und 80 g (2,0 mol) NaOH werden in 740 ml Wasser 20 min bei 60°C gerührt. Anschließend werden bei 60 bis 70°C langsam 168 ml (2,0 mol) Allylchlorid zugetropft. Es wird noch 12 Stunden unter Rückfluß auf 100°C erhitzt. Während dieser Zeit werden weitere 40 g (1 mol) NaOH, gelöst in 180 ml Wasser, und 84 ml (1 mol) des oben näher bezeichneten Allylchlorids in 2 Portionen zugetropft, dergestalt, daß der pH-Wert des Reaktionsgemisches stets größer als 7 bleibt.

Die organische Phase wird abgetrennt und die wässrige Phase dreimal mit tert.-Butylmethylether (käuflich erhältlich unter der Bezeichnung "Diveron S" bei den Chemischen Werken Hüls AG, D-4370 Marl) extrahiert. Die vereinigten organischen Phasen werden neutral gewaschen, über Natriumsulfat getrocknet und das Lösungsmittel im Vakuum abgezogen. Nach Destillation des Rückstandes im Vakuum verbleiben 377,5 g eines farblosen Öls, was einer Ausbeute von 98 % entspricht. Der Siedepunkt liegt bei einem Druck von 0,1 Torr zwischen 112 und 115°C.

Der so erhaltene 4-Allyloxy-3-methyoxybenzaldehyd zeigt in $CDCl_3$ im 200 MHz-$^1$H-NMR-Spektrum mit TMS als innerem Standard Signale bei 3,92 (s, 3H, -$OCH_3$), 4,71 (d, J=6Hz, 2H, -O-$CH_2$-), 5,35 (dd, J=10; 2Hz, 1H, $H_a\underline{H}_b$C=CH-$CH_2$-), 5,46 (dd, J=16; 2Hz, 1H, $\underline{H}_aH_b$C=CH-$CH_2$-), 6,10 (ddd, J=16; 10; 6Hz, 1H, $H_2$C=C$\underline{H}$-$CH_2$-), 6,98 (d, J=8Hz, 1H, 5-H), 7,41 (d, J=1Hz, 1H, 2-H) und 7,42 (dd, J=8Hz, 1H, 6-H) ppm.

c) Herstellung von 1,4-Bis-(4-allyloxy-3-methoxystyryl)benzol

Zu einem Gemisch aus 61,7 g (0,55 mol) Kalium-tert.-butylat, 4,8 g (18,3 mmol) 18-Krone-6, 1,14 g (6,9 mmol) Kaliumiodid und 1 000 ml Toluol werden bei einer Temperatur zwischen 0 und 10°C 89,1 g (0,44 mol) des oben unter b) beschriebenen 4-Allyloxy-3-methoxybenzaldehyds und 83,2 g (0,22 mol) des oben unter a) beschriebenen Benzol-1,4-bis-(methylenphosphonsäure)-tetraethylesters, gelöst in 500 ml Toluol, innerhalb von drei Stunden getropft. Anschließend wird noch 16 Stunden bei Raumtemperatur gerührt. Der entstandene Niederschlag wird abgesaugt, mit Wasser und Ethanol gewaschen und bei einem Druck von 10 Torr und 70°C getrocknet. Es verbleiben 87,1 g orangefarbener Kristalle mit einem Schmelzpunkt von 223°C (Toluol), was einer Ausbeute von 87 % entspricht.

Das so erhaltene 1,4-Bis-(4-allyloxy-3-methoxystyryl)-benzol zeigt in $CDCl_3$ im 200 MHz-$^1$H-NMR-Spektrum mit TMS als innerem Standard Signale bei 3,94 (s, 6H, 2 $CH_3$-O-), 4,65 (d, J=5Hz, 4H, 2 $H_2C=CH-C\underline{H}_2$-O-), 5,31 (dd, J=10; 2Hz, 2H, $H_a\underline{H}_bC=CH-CH_2$-), 5,43 (dd, J=16; 2Hz, 2H, $\underline{H}_aH_bC=CH-CH_2$-), 6,10 (ddd, J=16; 10; 5Hz, 2H, $H_aH_bC=C\underline{H}-CH_2$-), 6,87 (d, J=8Hz, 2H, $H^5$), 6,98 (d, J=16Hz, 2H, $H^2$ oder $H^{2'}$), 7,03 (dd, J=8; 2Hz, 2H, $H^4$), 7,05 (d, J=16Hz, 2H, $H^{2'}$ oder $H^2$), 7,08 (d, J=2Hz, 2H, $H^3$) und 7,48 (s, 4H, $H^1$) ppm, wobei sich folgende Struktureinheit ergibt:

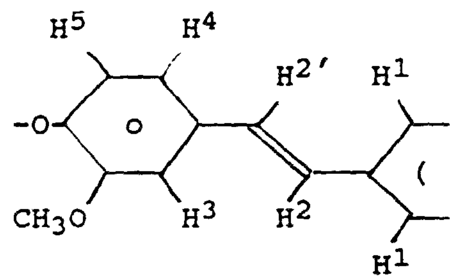

Das so erhaltene 1,4-Bis-(4-allyloxy-3-methoxystyryl)-benzol zeigt im Infrarotspektrum (KBr-Preßling) signifikante Banden bei 1650 (w), 1630 (w), 1596 (m), 1580 (m), 1520 (s), 1425 (s), 1280 (s), 1250 (s), 1230 (s), 1135 (s), 1010 (s) und 970 (s) $cm^{-1}$, sowie im
UV-Spektrum mit $CH_2Cl_2$ als Lösungsmittel
$\lambda_{max}$ (lg ε) = 373 nm (5,82).

5,0 g (11 mmol) des oben unter c) hergestellten 1,4-Bis-(4-allyloxy-3-methoxystyryl)-benzols und 3,35 g (5,75 mmol) 87%iges α,ω-Dihydrogentetradecamethylheptasiloxan, dessen Herstellung oben unter A beschrieben ist, werden in 100 ml Toluol auf 110°C erhitzt und mit 0,6 ml einer $1{,}27\cdot10^{-3}$ molaren Lösung von Dicyclopentadienylplatindichlorid, dessen Herstellung in Beispiel 1 unter d) beschrieben ist, in Trichlormethan versetzt. Anschließend werden während einer Zeitspanne von 2 Stunden weitere 3,35 g des oben näher bezeichneten α,ω-Dihydrogentetradecamethylheptasiloxans im Gemisch mit 0,6 ml der oben näher bezeichneten Dicyclopentadienylplatindichloridlösung zugetropft und nach beendeter Zugabe eine Stunde unter Rückfluß auf 110°C erhitzt. Zur Abtrennung der Platinrückstände wird das so erhaltene Gemisch über eine 5 cm hohe Kieselgel-Schicht (käuflich erhältlich unter der Bezeichnung Kieselgel 60, E. Merck, D-6100 Darmstadt) abgesaugt und das Filtrat im Vakuum eingeengt. Die verbleibende Lösung wird unter Rühren auf 300 ml Ethanol gegossen, wobei das erfindungsgemäße Poly(arylenvinylen-siloxan) ausfällt. Der Niederschlag wird abgesaugt und bei einer Temperatur von 70°C und einem Druck von 10 Torr getrocknet. Es verbleiben 8,5 g eines gelbgrünen Pulvers, was einer Ausbeute von 81 % entspricht, mit einem mittleren Molekulargewicht (Gewichtsmittel) $M_w$ von 43 500, einem Verhältnis von Gewichtsmittel zu numerischem Mittel $M_n$ von 2,36, einem mittleren Polymerisationsgrad von 45,3 und folgender Wiederholungseinheit

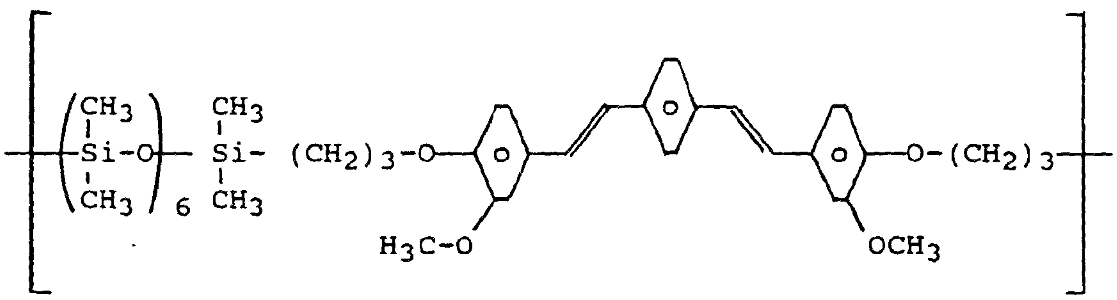

Das erfindungsgemäße Poly(arylenvinylen-siloxan) hat eine Inhärentviskosität von 0,50 dl/g, einen Glaspunkt $T_g$ bei 8°C, eine Zersetzungstemperatur bei 365°C unter Luft und 385°C unter Stickstoff und unterhalb des Klärpunktes bei 38°C eine smektisch-C-Schichtstruktur, wobei der Schichtabstand 3,6 nm beträgt.

Das erfindungsgemäße Poly(arylenvinylen-siloxan) zeigt in $CDCl_3$ im 200 MHz-$^1$H-NMR-Spektrum mit TMS als innerem Standard Signale bei 0,13 (m, 42H, 14x Si-$CH_3$), 0,68 (m, 4H, Si-$CH_2$-), 1,92 (m, 4H, Si-$CH_2$-$C\underline{H}_2$-), 3,96 (s, 6H, 2x -$OCH_3$), 4,03 (t, J=7Hz, 4H, Si-$CH_2$-$CH_2$-$C\underline{H}_2$-O-), 6,88 (d, J=8Hz, 2H, $H^5$), 7,00 (d, J=16Hz, 2H, $H^2$ oder $H^{2'}$), 7,04 (dd, J=8; 2Hz, 2H, $H^4$), 7,06 (d, J=16Hz, 2H, $H^2$ oder $H^{2'}$), 7,10 (d, J=2Hz, 2H, $H^3$) und 7,49 (s, 4H, $H^1$) ppm, wobei sich folgende Struktureinheit ergibt:

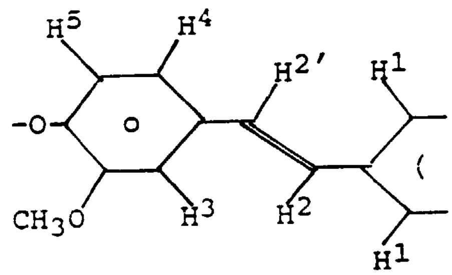

Das Infrarotspektrum (Film) zeigt signifikante Banden bei 1600 (m), 1580 (m), 1515 (s), 1465 (m), 1450 (m), 1420 (m), 1258 (s), 1080 (s), 1025 (s), 960 (m), 917 (m) und 800 (s) $cm^{-1}$.
und im UV-Spektrum mit Tetrahydrofuran als Lösungsmittel
$\lambda_{max}$ (lg $\varepsilon$) = 351 nm (4,52).

**Beispiel 3**

a) Herstellung von 1-(3-Butenyl)-4-chlorbenzol

Zu 85,1 g (3,5 mol) Magnesiumspänen in 1,0 l wasserfreiem Tetrahydrofuran werden unter starkem Rühren während 4 Stunden 119,6 ml (1,45 mol) Allylchlorid, gelöst in 500 ml wasserfreiem Tetrahydrofuran, getropft. Anschließend wird die magnesiumorganische Verbindung in einen Tropftrichter gegeben und unter Eiskühlung zu einer Lösung von 198,1 g (1,20 mol) 4-Chlorbenzylchlorid in 400 ml wasserfreiem Tetrahydrofuran getropft. Nach üblicher Aufarbeitung verbleiben 197,7 g eines farblosen Öls, was einer Ausbeute von 98 % entspricht. Gemäß gaschromatischer Untersuchung beträgt der Reinheitsgrad 99 %.

Das so erhaltene 1-(3-Butenyl)-4-chlorbenzol zeigt in $CDCl_3$ im 200 MHz-$^1$H-NMR-Spektrum mit TMS als innerem Standard Signale bei 2,33 (dt, J=7; 7Hz, 2H, $H_2C$=CH-$C\underline{H}_2$-), 2,67 (t, J=7Hz, 2H, -Ar-$CH_2$-), 4,98 (dd, J=10; 2Hz, 1H, $H_a\underline{H}_b$C=CH-$CH_2$-), 5,01 (dd, J=16; 2Hz, 1H, $\underline{H}_aH_b$C=CH-$CH_2$-), 5,82 (ddt, J=16; 10; 7Hz, 1H, $H_2$C=C$\underline{H}$-$CH_2$-) und 7,17 (AA'BB'-Spektrum; 4H, -Ar-) ppm, wobei Ar Aromat bedeutet.

b) Herstellung von 4-(3-Butenyl)-benzaldehyd

Zu 10,9 g (0,45 mol) mit Jod angeätzten Magnesiumspänen in 50 ml wasserfreiem Tetrahydrofuran wird nach dem Zusatz von 0,5 ml Ethylbromid innerhalb von 2,5 Stunden bei 65°C eine Lösung von 50 g (0,30 mol) des oben unter

a) beschriebenen 1-(3-Butenyl)-4-chlorbenzols in 50 ml wasserfreiem Tetrahydrofuran getropft. Anschließend läßt man noch 4,5 Stunden bei 70°C rühren. Die so erhaltene Lösung wird vom überschüssigen Magnesium abdekantiert, in einen Tropftrichter gegeben und bei 0 bis 5°C zu einer Lösung von 29 ml (0,375 mol) N,N-Dimethylformamid in 450 ml wasserfreiem Tetrahydrofuran getropft. Nach üblicher Aufarbeitung verbleiben 43,3 g eines farblosen Öls, was einer Ausbeute von 90 % entspricht. Gemäß gaschromatographischer Untersuchungen beträgt der Reinheitsgrad 83 %. Nach Destillation über eine 30 cm lange Füllkörperkolonne erhält man 30,3 g eines farblosen Öles, welches bei einem Druck von 2,25 Torr einen Siedepunkt zwischen 99 und 100°C aufweist.

Der so erhaltene 4-(3-butenyl)-benzaldehyd zeigt in $CDCl_2$ im 200 MHz-$^1$H-NMR-Spektrum mit TMS als innerem Standard Signale bei 2,38 (dt, J=7; 7Hz, 2H, $H_2C{=}CH{-}C\underline{H}_2{-}$), 2,76 (t, J=7Hz, 2H, $-Ar-CH_2-$), 4,99 (dd, J=10; 2Hz, 1H, $H_a\underline{H}_bC{=}CH{-}CH_2{-}$), 5,03 (dd, J=16; 2Hz, 1H, $\underline{H}_aH_bC{=}CH{-}CH_2{-}$), 5,82 (ddt, J=16; 10; 7Hz, 1H, $H_2C{=}C\underline{H}{-}CH_2{-}$) und 7,54 (AA'BB'-Spektrum; 4H, -Ar-) ppm, wobei Ar Aromat bedeutet.

c) Herstellung von 4-Chlorbenzylphosphonsäurediethylester

Zu 700 ml (4 mol) Triethylphosphit werden unter Rühren bei 135°C langsam 645 g (4 mol) 4-Chlorbenzylchlorid getropft, wobei das entstehende Chlorethan in einer gekühlten Vorlage kondensiert wird. Nach beendeter Zugabe des 4-Chlorbenzylchlorids wird noch 5 Stunden auf 140°C erhitzt. Anschließend wird im Ölpumpenvakuum fraktioniert destilliert. Es verbleiben 843 g eines farblosen Öls, was einer Ausbeute von 80 % entspricht. Der Siedepunkt liegt bei einem Druck von 0,7 Torr bei 155°C.

Der so erhaltene 4-Chlorbenzylphosphonsäurediethylester zeigt in $CDCl_3$ im 200 MHz-$^1$H-NMR-Spektrum mit TMS als innerem Standard Signale bei 1,25 (t, J=7Hz, 6H, 2x $-CH_3$), 3,08 (d, J=22Hz, 2H, $P-CH_2-Ar$), 4,00 (dq, J=7; 7Hz, 4H, 2x $P{-}O{-}C\underline{H}_2{-}CH_3$) und 7,21 (m, schmal; 4H, -Ar-) ppm, wobei Ar Aromat bedeutet.

d) Herstellung von Biphenyl-4,4'-bis-(methylenphosphonsäure)-tetraethylester

Analog einer Vorschrift von J. Colon und D.R. Kelsey, J.Org.Chem. 51 (1986) 2627, werden 327 g (5,0 mol) Zink-Granulat (30 mesh) 38,6 g (0,188 mol) Natriumbromid, 16,2 g (0,125 mol) Nickelchlorid, 320 g (1,25 mol) Triphenylphosphan und 7,03 g (0,62 mol) 2,2'-Bipyridyl in 1200 ml wasserfreiem N,N-Dimethylformamid während 2 Stunden auf 60°C erhitzt, wobei sich die Reaktionsmischung rotbraun verfärbt. Dann werden 656,5 g (2,5 mol) des oben unter c) beschriebenen 4-Chlorbenzylphosphonsäurediethylesters, gelöst in 250 ml N,N-Dimethylformamid, bei 60-90°C während 2 Stunden zugetropft und anschließend 2 Stunden bei 80°C gerührt. Nach dem Abkühlen wird die so erhaltene Lösung über eine 2 cm hohe Tonsil-Schicht (käuflich erhältlich bei der Süd-Chemie AG, D-8000 München) filtriert und das Filtrat im Vakuum eingeengt. Der Rückstand wird in 1 l Toluol aufgenommen, mit 3 %iger Salzsäure eine Stunde lang extrahiert und dann mit Wasser neutral gewaschen. Nach dem Trocknen über $Na_2SO_4$, Abkühlen und Absaugen verbleiben 318,3 g weißer Kristalle, was einer Ausbeute vcn 56 % entspricht. Der Schmelzpunkt liegt bei 112°C.

Der so erhaltene Biphenyl-4,4'-bis-(methylenphosphonsäure)-tetraethylester zeigt in $CDCl_3$ im 200 MHz-$^1$H-NMR-Spektrum mit TMS als innerem Standard Signale bei 1,25 (t, J=7Hz, 12H, 4x $-CH_3$), 3,20 (d, J=22Hz, 4H, 2x $P-CH_2-Ar-$), 4,05 (dq, J=7; 7Hz, 8H, 4x $P{-}O{-}\underline{C}H_2{-}CH_3$), 7,38 (dd, J=8; 2Hz, 4H, Ar-3,3',5,5'-H) und 7,56 (d, J=8Hz, 4H, Ar-2,2',6,6'-H) ppm, wobei Ar Aromat bedeutet.

e) Herstellung von 4,4'-Bis-(4-(3-butenyl)-styryl)biphenyl

Zu einer Suspension von 19 g (167 mmol) Kalium-tert.-butylat und einer Spatelspitze 18-Krone-6 in 200 ml Anisol wird unter Rühren und bei einer Temperatur von 10 bis 20°C eine Lösung von 36,5 g (79 mmol) des oben unter d) beschriebenen Biphenyl-4,4'-bis-(methylenphosphonsäure)-tetraethylesters und 25,8 g (159 mmol) des oben unter b) beschriebenen 4-(3-Butenyl)-benzaldehyds in 400 ml Anisol getropft und anschließend 1 Stunde bei 50°C gerührt. Nach dem Abkühlen auf Raumtemperatur wird der entstandene Feststoff abgesaugt, mit Wasser und tert.-Butylmethylether gewaschen und im Vakuum bei 70°C getrocknet. Es verbleiben 24,6 g eines gelben Pulvers, was einer Ausbeute von 66 % entspricht. Der Schmelzpunkt, der zugleich Zersetzungspunkt ist, liegt bei 320°c.

Das so erhaltene 4,4'-Bis-(4-(3-butenyl)-styryl)-biphenyl zeigt in $CDCl_3$ im 200 MHz-$^1$H-NMR-Spektrum mit TMS als innerem Standard Signale bei 2,39 (dt, J=6; 7Hz, 4H, 2x $={CH}{-}C\underline{H}_2{-}CH_2{-}$), 2,73 (t, J=7Hz, 4H, 2x $-Ar-CH_2-$), 5,00 (dd, J=10; 2Hz, 2H, 2x $H_a\underline{H}_bc{=}CH{-}CH_2{-}$), 5,06 (dd, J=16Hz, 2H, 2x $\underline{H}_aH_b$ $C{=}CH{-}CH_2{-}$), 5,88 (ddd, J=16; 10; 6Hz, 2H, 2x $H_2C{=}C\underline{H}{-}CH_2{-}$), 7,15 (s, 4H, 2x $Ar{-}C\underline{H}{=}C\underline{H}{-}Ar$), 7,34 (AA'BB'-Spektrum; 8H, 2x $-CH_2-\underline{Ar}-CH=$) und 7,62 (AA'BB'-Spektrum; 8H, -Ar-Ar-) ppm, wobei Ar Aromat bedeutet.

4,8 g (10 mmol) des oben unter e) beschriebenen 4,4'-Bis-(4-(3-butenyl)-styryl)-biphenyls und 7,0 g (10 mmol) des oben unter A beschriebenen α,ω-Dihydrogeneicosamethyldecasiloxans werden in 100 ml Toluol unter Rühren auf eine Temperatur von 110°C erhitzt und anschließend mit 0,08 ml einer $1{,}27 \cdot 10^{-3}$ molaren Lösung von Dicyclopentadienylplatindichlorid, dessen Herstellung in Beispiel 1 unter d) beschrieben ist, in Chloroform versetzt und dann etwa

2 Stunden unter Rückfluß auf 110°C erhitzt. Nach dem Abkühlen wird das so erhaltene Gemisch zur Abtrennung der Platinrückstände über eine 5 cm hohe Kieselgel-Schicht (käuflich erhältlich unter der Bezeichnung Kieselgel 60, E. Merck, D-6100 Darmstadt) abgesaugt und anschließend auf ein Volumen von 50 ml im Vakuum eingeengt. Die verbleibende Lösung wird unter Rühren auf 250 ml Ethanol gegossen, wobei das erfindungsgemäße Poly(arylenvinylen-siloxan) ausfällt. Der Niederschlag wird abgesaugt und bei einer Temperatur von 70°C und einem Druck von 10 Torr getrocknet. Es verbleiben 7,6 g eines gelben Pulvers, was einer Ausbeute von 64 % entspricht mit einem mittleren Molekulargewicht (Gewichtsmittel) $M_w$ von 32 040, einem Verhältnis von Gewichtsmittel $M_w$ zu numerischem Mittel $M_n$ von 3,09, einem mittleren Polymerisationsgrad $P_w$ von 26,8 mit folgender Wiederholungseinheit

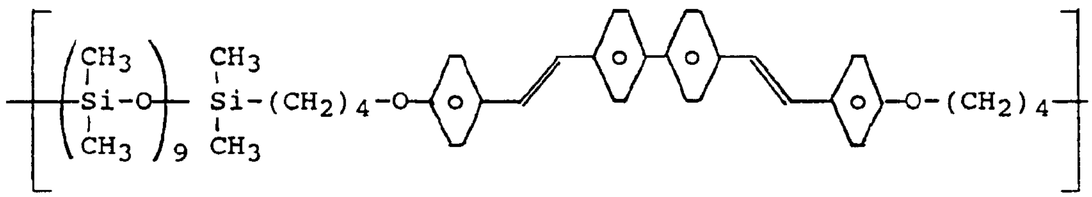

Das erfindungsgemäße Poly(arylenvinylen-siloxan) hat eine Inhärentviskosität von 0,49 dl/g, einen Glaspunkt $T_g$ bei -54°C, eine Zersetzungstemperatur bei 370°C unter Luft und bei 405°C unter Stickstoff und unterhalb des Klärpunktes bei 177°C eine smektisch-C-Schichtstruktur, wobei der Schichtabstand 4,4 nm beträgt.

Das erfindungsgemäße Poly(arylenvinylen-siloxan) zeigt in $CDCl_3$ im 200 MHz-$^1$H-NMR-Spektrum mit TMS als innerem Standard Signale bei 0,13 (m, 60H, 20x Si-$CH_3$), 0,65 (m, 4H, 2x Si-$CH_2$), 1,45 (tt, J=7; 7Hz, 4H, 2x Si-$CH_2$-$CH_2$-), 1,71 (tt, J=8; 8Hz, 4H, 2x Si-$CH_2$-$CH_2$-$CH_2$-), 2,67 (t, J=7Hz, 4H, 2x Si-$CH_2$-$CH_2$-$CH_2$-$CH_2$-Ar), 7,18 (s, 4H, 2x -CH=CH-), 7,36 (AA'BB'-Spektrum; 8H, -$CH_2$-Ar-CH=) und 7,65 (AA'BB'-Spektrum; 8H, -Ar-Ar-) ppm, wobei Ar Aromat bedeutet,
im Infrarotspektrum (KBr-Preßling) signifikante Banden bei 1512 (w), 1493 (w), 1415 (w), 1260 (s), 1095 (s), 1025 (s) und 800 (s) $cm^{-1}$ sowie
im UV-Spektrum in Tetrahydrofuran als Lösungsmittel
$\lambda_{max}$ (lgε) = 350 nm (4,63).

**Beispiel 4**

a) Herstellung von 4,4'-Bis-(4-allyloxy-3-methoxystyryl)biphenyl

Zu einer Suspension von 56 g (0,49 mol) Kalium-tert.-butylat und einer Spatelspitze 18-Krone-6 in 1500 ml Anisol wird unter Rühren und bei einer Temperatur von 10 bis 20°C eine Lösung von 101 g (0,22 mol) des in Beispiel 3 unter d) beschriebenen Biphenyl-4,4'-bis-(methylenphosphonsäure)-tetraethylesters und 92,6 g (0,44 mol) des in Beispiel 2 unter b) beschriebenen 4-Allyloxy-3-methoxybenzaldehyds in 600 ml Anisol getropft und anschließend 1 Stunde bei 50°C gerührt. Nach dem Abkühlen auf Raumtemperatur wird der entstandene Feststoff abgesaugt, mit Wasser und tert.-Butylmethylether gewaschen und im Vakuum bei 70°C getrocknet. Es verbleiben 84,7 g eines gelben Pulvers mit einem Schmelzpunkt von 250°C (N,N-Dimethylformamid), was einer Ausbeute von 73 % entspricht.

Das so erhaltene 4,4'-Bis-(4-allyloxy-3-methoxystyryl)biphenyl zeigt in $CDCl_3$ im 200 MHz-$^1$H-NMR-Spektrum mit TMS als innerem Standard Signale bei 3,95 (s, 6H, -$OCH_3$), 4,66 (d, J=6Hz, 4H, -Ar-O-$CH_2$-), 5,31 (dd, J=10; 2Hz, 2H, 2x $H_aH_b$C=CH-$CH_2$-), 5,42 (dd, J=16; 2Hz, 2H, 2x $H_aH_b$C=CH-$CH_2$), 6,12 (ddd, J=16; 10; 6Hz, 2H, 2x $H_2$C=CH-$CH_2$-), 6,89 (d, J=8Hz, $H^5$), 7,01 (d, J=16Hz, 2H, $H^2$ oder $H^{2'}$), 7,06 (dd, J=8; 2Hz, 2H, $H^4$), 7,10 (d, J=16Hz, 2H, $H^{2'}$ oder $H^2$), 7,10 (d, J=2Hz, 2H, $H^3$) und 7,61 (AA'BB'-Spektrum; 8H, -Ar-Ar-) ppm mit Ar gleich Aromat und wobei sich folgende Struktureinheit ergibt

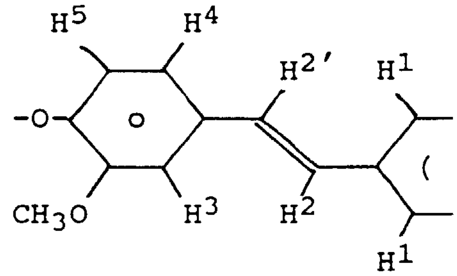

10,6 g (20 mmol) des oben unter a) beschriebenen 4,4'-Bis-(4-allyloxy-3-methoxystyryl)-biphenyls und 15,5 g (20 mmol) des oben unter A beschriebenen $\alpha,\omega$-Dihydrogeneicosamethyldecasiloxans werden in 120 ml Anisol unter Rühren und unter einer Argon-Atmosphäre auf 120°C erhitzt und anschließend mit 0,8 mg ($2 \cdot 10^{-6}$ mol) des in Beispiel 1 unter d) beschriebenen Dicyclopentadienylplatindichlorids versetzt und dann etwa 3 Stunden auf 150°C erhitzt. Nach dem Abkühlen wird das so erhaltene Gemisch zur Abtrennung der Platinrückstände über eine 5 cm hohe Kieselgel-Schicht (käuflich erhältlich unter der Bezeichnung Kieselgel 60, E. Merck, D-6100 Darmstadt) filtriert, das Filtrat im Vakuum weitgehend eingeengt und mit 200 ml Petrolether versetzt. Vom ausgefallenen Niederschlag wird abfiltriert und das Filtrat im Vakuum bis zur Trockene eingeengt. Dieser Rückstand wird in 100 ml Petrolether aufgenommen und dann auf 350 ml Ethanol gegossen. Der ausgefallene Niederschlag wird abgesaugt und im Vakuum bei 70°C getrocknet. Es verbleiben 16,8 g eines gelben Pulvers, was einer Ausbeute von 67 % mit einem mittleren Molekulargewicht (Gewichtsmittel) $M_w$ von 16 000, einem Verhältnis von Gewichtsmittel $M_w$ zu numerischem Mittel $M_n$ von 1,88, einem mittleren Polymerisationsgrad $P_w$ von 12,7 mit folgender Wiederholungseinheit

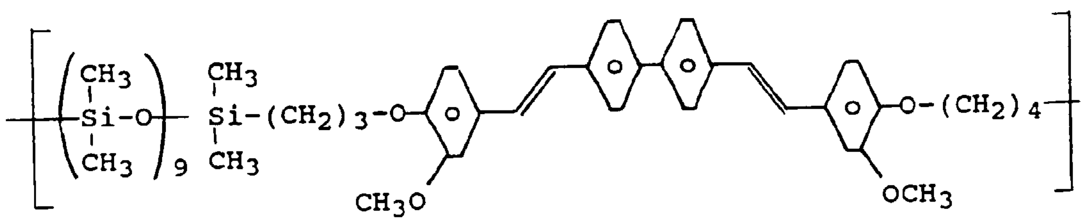

Das erfindungsgemäße Poly(arylenvinylen-siloxan) hat eine Inhärentviskosität von 0,22 dl/g, einen Glaspunkt $T_g$ bei -3°C, eine Zersetzungstemperatur von 345°C unter Luft und 380°C unter Stickstoff und unterhalb des Klärpunktes bei 194°C eine smektisch-C-Schichtstruktur, wobei der Schichtabstand 4,3 nm beträgt.

Das erfindungsgemäße Poly(arylenvinylen-siloxan) zeigt in $CDCl_3$ im 200 MHz-$^1$H-NMR-Spektrum mit TMS als innerem Standard Signale bei 0,13 (m, 60H, 20x Si-$CH_3$), 0,73 (m, 4H, 2x Si-$CH_2$), 1,97 (m, 4H, 2x Si-$CH_2$-C$\underline{H}_2$-), 4,00 (s, 6H, 2x $OCH_3$), 4,08 (t, J=7Hz, 4H, 2x Si-$CH_2$-$CH_2$-C$\underline{H}_2$-O-), 6,93 (d, J=8Hz, 2H, $H^5$), 7,06 (d, J=16Hz, 2H, $H^2$ oder $H^{2'}$), 7,11 (dd, J=8; 2Hz, 2H, $H^4$), 7,15 (d, J=2Hz, 2H, $H^3$), 7,17 (d, J=16Hz, 2H, $H^{2'}$ oder $H^2$) und 7,66 (AA'BB'-Spektrum; 8H, -Ar-Ar) ppm mit Ar gleich Aromat, wobei sich folgende Struktureinheit ergibt

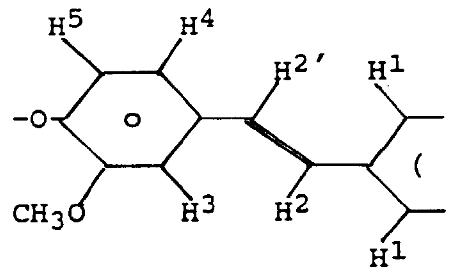

im Infrarotspektrum (KBr-Preßling) signifikante Banden bei 1595 (w), 1512 (m), 1465 (w), 1417 (w), 1260 (s), 1090 (s), 1025 (s) und 800 (s) $cm^{-1}$ sowie

im UV-Spektrum in Tetrahydrofuran als Lösungsmittel
$\lambda_{max}$ (lg ε) = 365 nm (5,79).

**Beispiel 5**

a) Herstellung von 4,4'-Dimethyl-trans-stilben

Zu einer Suspension von 239,7 g (2,13 mol) Kalium-tert.-butylat, 16,2 g (61 mmol) 18-Krone-6 und 4,6 g (28 mmol) Kaliumiodid in 2,5 l Toluol wird bei 0 bis 10° C unter Rühren eine Lösung von 432 g (1,78 mol) 4-Methylbenzylphosphonsäurediethylester und 210 ml (1,78 mol) Toluolaldehyd in 1 l Toluol getropft. Die ausfallenden Kristalle werden abgesaugt, mit Wasser gewaschen und aus Ethanol umkristallisiert. Es verbleiben 312,3 g heller, nadelförmiger Kristalle mit einem Schmelzpunkt zwischen 184 und 186° C, was einer Ausbeute von 85 % entspricht.

Das so erhaltene 4,4'-Dimethyl-trans-stilben zeigt in $CDCl_3$ im 200 MHz-$^1$H-NMR-Spektrum mit TMS als innerem Standard Signale bei 2,35 (s, 6H, 2x-$CH_3$), 7,05 (s, 2H, -CH=CH-), 7,28 (AA'BB'-Spektrum; 8H, 2x-Ar-) ppm, wobei Ar Aromat bedeutet.

b) Herstellung von 4,4'-Bis-(brommethyl)-stilben

162,8 g (0,78 mol) des oben unter a) beschriebenen 4,4'-Di-methylstilbens, 320 g (1,79 mol) N-Bromsuccinimid und 6,5 g Azobisisobutyronitril wurden 6 Stunden in 1,5 l Tetrachlorkohlenstoff unter Rückfluß erhitzt. Der erhaltene Feststoff wird abgesaugt, mit heißem Ethanol gewaschen und im Vakuum getrocknet. Es verbleiben 189,4 g hellgelber Kristalle mit einem Schmelzpunkt zwischen 182 und 184° C, was einer Ausbeute von 60% entspricht.

Das so erhaltene 4,4'-Bis-(brommethyl)-stilben zeigt in $CDCl_3$ im 200 MHz-$^1$H-NMR-Spektrum mit TMS als innerem Standard Signale bei 4,53 (s, 4H, 2x Ar-$CH_2$-Br), 7,11 (s, 2H, - CH=CH-) und 7,43 (AA'BB'-Spektrum; 8H, 2x-Ar-) ppm, wobei Ar Aromat bedeutet.

c) Herstellung von Stilben-4,4'-(methylenphosphonsäure)-tetraethylester

Analog zu den in Beispiel 2 a) beschriebenen Arbeitsweise werden 356,6 g (0,95 mol) des oben unter b) beschriebenen 4,4'-Bis-(brommethyl)-stilbens mit 356,1 g (2,10 mol) Triethylphosphit umgesetzt. Es verbleiben 445,4 g gelber Kristalle mit einem Schmelzpunkt zwischen 141 und 143° C, was einer Ausbeute von 97 % entspricht.

Der so erhaltene Stilben-4,4'-bis-(methylenphosphonsäure)tetraethylester zeigt in $CDCl_3$ im 200 MHz-$^1$H-NMR-Spektrum mit TMS als innerem Standard Signale bei 1,25 (t, J=7Hz, 12H, 4x-$CH_3$), 3,18 (d, J=22Hz; 4H, 2x-Ar-$CH_2$-P), 4,03 (dq, J= 7; 7Hz; 8H, 2x P(O-C$\underline{H}_2$-$CH_3$)$_2$), 7,07 (s, 2H, -CH=CH-), 7,29 (dd, J=8; 2Hz, 4H, -Ar-, 2,2',5,5'-H) und 7,46 (d, J=8Hz, 4 H, -Ar-, 2,2',6,6'-H) ppm, wobei Ar Aromat bedeutet.

d) Herstellung von 4,4'-Bis-(4-allyloxy-3-methoxystyryl)stilben

Zu einer Suspension von 94,4 g (841 mmol) Kalium-tert.-butylat, 6,1 g (23 mmol) 18-Krone-6 und 1,75 g (10 mmol) Kaliumiodid in 1300 ml Anisol wird unter Rühren und bei einer Temperatur von 0 bis 10° C eine Lösung von 147,0 g (306 mmol) des oben unter c) beschriebenen Stilben-4,4'-bis-(methylenphosphonsäure)-tetraethylesters und 129,4 g (673 mmol) des in Beispiel 2 unter b) beschriebenen 4-Allyloxy-3-methoxybenzaldehyds in 900 ml Anisol getropft und anschließend noch 1 Stunde bei Raumtemperatur und dann noch 3 Stunden bei 110° C gerührt. Nach dem Abkühlen auf Raumtemperatur wird der entstandene Feststoff abgesaugt und erst aus Dimethylsulfoxid und dann aus Veratrol (1,2-Dimethoxybenzol) umkristallisiert. Es verbleiben 119,5 g gelber Kristalle, was einer Ausbeute von 73 % entspricht.

Das so erhaltene 4,4'-Bis-(4-allyloxy-3-methoxystyryl)-stilben zeigt in einem $CDCl_3$/DMSO-$d_6$ (9 : 1)-Lösungsmittelgemisch im 200 MHz-$^1$H-NMR-Spektrum mit TMS als innerem Standard Signale bei 3,95 (s, 6H, -$OCH_3$), 4,64 (d, J=6Hz, 4H, -Ar-O-$CH_2$-), 5,31("d", J=10Hz, 2H, 2 x $H_a\underline{H}_b$C=CH-$CH_2$-), 5,44 ("d", J=16Hz, 2H, $\underline{H}_aH_b$C=C$\underline{H}$-$CH_2$-), 6,10 (ddd, J=16; 10; 6 Hz, 2H, $H_2$C=C$\underline{H}$-$CH_2$-), 6,91 ("d", J=8 Hz, 2H, $H^5$), 7,01 (d, J=16 Hz, 2H, $H^2$ oder $H^2$), 7,12 (d, J=16 Hz, 2H, $H^{2'}$ oder $H^2$), 7,13 ("d", J=8 Hz, 2H, $H^4$), 7,16 ("s", 2H, $H^3$), 7,16 ("s", 2H, -CH=CH-) und 7,54 (m, schmal, 8H, -$\underline{Ar}$-CH=CH-$\underline{Ar}$-) ppm, wobei Ar Aromat bedeutet und sich folgende Struktureinheit ergibt:

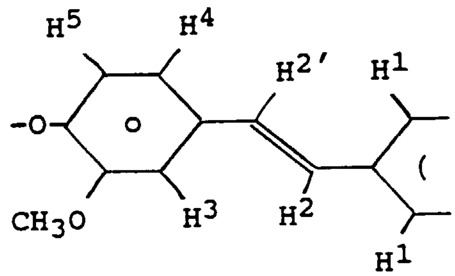

Das so erhaltene 4, 4'-Bis-(4-allyloxy-3-methoxystyryl)-stilben zeigt im Infrarotspektrum (KBr-Preßling) signifikante Banden bei 1590 (w), 1517 (s), 1422 (w), 1283 (m), 1270 (m), 1250 (s), 1230 (m), 1135 (s) und 966 (m) $cm^{-1}$.

2,0 g (3,7 mmol) des oben unter d) hergestellten 4,4'-Bis-(4-allyloxy-3-methoxystyryl)-stilbens und 2,5 g (3,4 mmol) $\alpha,\omega$-Dihydrogeneicosamethyldecasiloxan, dessen Herstellung oben unter A beschrieben ist, werden in 300 ml wasserfreiem Anisol auf 150°C erhitzt und mit 0,4 ml einer $1{,}27 \cdot 10^{-3}$ molaren Lösung von Dicyclopentadienylplatindichlorid, dessen Herstellung in Beispiel 1 unter d) beschrieben ist, in Trichlormethan versetzt. Anschließend werden während einer Zeitspanne von 30 Minuten weitere 0,9 g (1,2 mmol) des oben näher bezeichneten $\alpha,\omega$-Dihydrogeneicosamethyldecasiloxans zugetropft und nach beendeter Zugabe 3,5 Stunden unter Rückfluß auf 154°C erhitzt. Nach dem Abkühlen auf Raumtemperatur wird die Reaktionslösung unter Rühren auf 2000 ml Ethanol gegossen, wobei das erfindungsgemäße Poly(arylenvinylen-siloxan) ausfällt. Der Niederschlag wird abgesaugt, erneut aus THF/Methanol umgefällt, abgesaugt und bei einer Temperatur von 70°C und einem Druck von 10 Torr getrocknet. Es verbleiben 3,13 g eines gelbgrünen Pulvers, was einer Ausbeute von 66% entspricht, mit einem mittleren Molekulargewicht (Gewichtsmittel) $M_w$ von 16 800, einem Verhältnis von Gewichtsmittel $M_w$ zu numerischem Mittel $M_n$ von 1,93, einem mittleren Polymerisationsgrad von 13,3 und folgender Wiederholungseinheit:

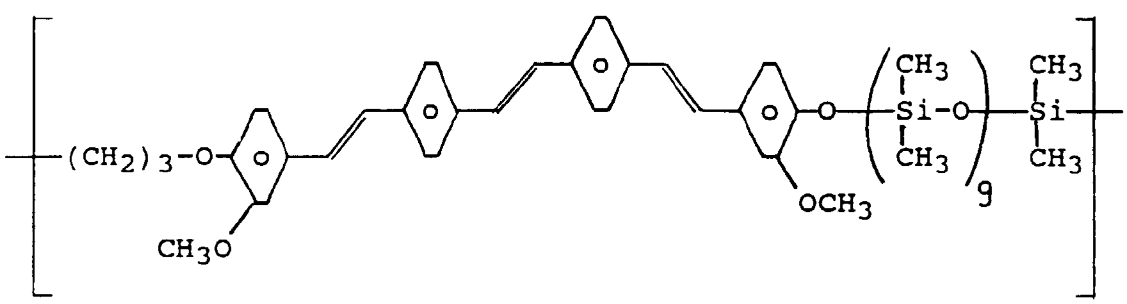

Das erfindungsgemäße Poly(arylenvinylen-siloxan) hat eine Inhärentviskosität von 0,19 dl/g, zwei Glaspunkte bei -94 und +14°C, eine Zersetzungstemperatur bei 352°C unter Luft und 380°C unter Stickstoff und unterhalb des Klärpunktes bei 220°C eine smektisch-C-Schichtstruktur, wobei der Schichtabstand 4,4 nm beträgt.

Das erfindungsgemäße Poly(arylenvinylen-siloxan) zeigt in $CDCl_3$ im 300 MHz-$^1$H-NMR-Spektrum mit TMS als innerem Standard Signale bei 0,08 (m, 60H, 20x Si-$CH_3$), 0.65 (m, 4H, 2x Si-$CH_2$-), 1,89 (m, 4H, 2x Si-$CH_2$-C$\underline{H}_2$-), 3,93 (s, 6H, 2x $OCH_3$), 3,99 (t, J=7Hz, 4H, 2x Si-$CH_2$-$CH_2$-C$\underline{H}_2$-O-), 6,83 - 7,45 (Multipletts, 12H,$(\text{-O-})_2C_6H_3$-CH=CH-, -CH=CH-) und 7,48 (m, schmal, 8H, -$\underline{Ar}$-CH=CH-$\underline{Ar}$-) ppm, wobei Ar Aromat bedeutet, und im Infrarotspektrum (KBr-Preßling) signifikante Banden bei 1516 (m), 1260 (s), 1090 (s), 1025 (s) und 800 (s) $cm^{-1}$ sowie im UV-Spektrum in Tetrahydrofuran als Lösungsmittel

$\lambda_{max}$ (lgε) = 395 nm (4,91).

**Beispiel 6**

Die in Beispiel 1 beschriebene Verfahrensweise wird wiederholt mit der Abänderung, daß anstelle des $\alpha,\omega$-Dihydrogendodecamethylhexasiloxans ein nach Arbeitsweise A hergestelltes Siloxan der Formel

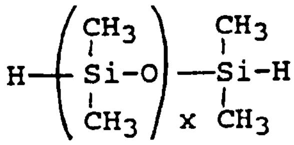

(IX),

worin x jeweils die in Tabelle 1 angegebene Bedeutung hat, eingesetzt wird. Es werden Poly(arylenvinylen-siloxane) mit den in Tabelle 1 angegebenen Ausbeuten, $M_w$, $M_w/M_n$, $P_w$, $T_g$, $T_i$ und d erhalten.

Tabelle 1

| Versuch | x | Ausbeute [%] | $M_w$ | $M_w/M_n$ | $P_w$ | $T_g$ [°C] | $T_i$ [°C] | d [nm] |
|---|---|---|---|---|---|---|---|---|
| 6.1 | 4 | 82 | 16 400 | 1,94 | 22 | 108 | 148 | 2,9 |
| 6.2 | 7 | 66 | 17 300 | 2,25 | 18 | 56 | 109 | 3,0 |
| 6.3 | 8 | 71 | 25 000 | 2,08 | 24 | 70 | 124 | 3,2 |
| 6.4 | 11 | 60 | 57 400 | 3,24 | 45 | 80 | 112 | 4,1 |
| 6.5 | 19 | 54 | 35 000 | 2,13 | 19 | 25 | 64 | 5,0 |

**Beispiel 7**

Die in Beispiel 2 beschriebene Verfahrensweise wird wiederholt mit der Abänderung, daß anstelle des α,ω-Dihydrogentetradecamethylheptasiloxans ein nach Arbeitsweise A hergestelltes Siloxan gemäß Formel (IX) eingesetzt wird, worin x jeweils die in Tabelle 2 angegebene Bedeutung hat.

Es werden Poly(arylenvinylen-siloxane) mit den in Tabelle 2 angegebenen Ausbeuten, $M_w$, $M_w/M_n$, $P_w$, $T_g$, $T_i$ und d erhalten.

Tabelle 2

| Versuch | x | Ausbeute [%] | $M_w$ | $M_w/M_n$ | $P_w$ | $T_g$ [°C] | $T_i$ [°C] | d [nm] |
|---|---|---|---|---|---|---|---|---|
| 7.1 | 3 | 65 | 10 000 | 1,90 | 13 | 42 | 64 | 2,8 |
| 7.2 | 5 | 55 | 12 800 | 1,79 | 14 | 40 | 98 | 2,9 |
| 7.3 | 9 | 79 | 62 500 | 1,98 | 53 | 50 | 69 | 3,7 |
| 7.4 | 11 | 70 | 52 400 | 1,71 | 39 | 14 | 73 | 3,8 |

**Beispiel 8**

Die in Beispiel 3 beschriebene Verfahrensweise wird wiederholt mit der Abänderung, daß anstelle des α,ω-Dihydrogeneicosamethyldecasiloxans ein nach Arbeitsweise A hergestellte Siloxan gemäß Formel (IX) eingesetzt wird, worin x jeweils die in Tabelle 3 angegebene Bedeutung hat. Es werden Poly(arylenvinylen-siloxane) mit den in Tabelle 3 angegebenen Ausbeuten, $M_w$, $M_w/M_n$, $P_w$, $T_g$, $T_i$ und d erhalten.

Tabelle 3

| Versuch | x | Ausbeute [%] | $M_w$ | $M_w/M_n$ | $P_w$ | $T_g$ [°C] | $T_i$ [°C] | d [nm] |
|---|---|---|---|---|---|---|---|---|
| 8.1 | 6 | 50 | 8 300 | 1,71 | 9 | -91 | 236 | 4,1 |
| 8.2 | 8 | 59 | 20 600 | 2,12 | 21 | -90/14 | 263 | - |
| 8.3 | 11 | 27 | 48 100 | 3,99 | 36 | -66 | 200 | 4,6 |
| 8.4 | 19 | 26 | 34 200 | 2,45 | 18 | -113 | 114 | - |

**Beispiel 9**

Die in Beispiel 4 beschriebene Verfahrensweise wird wiederholt mit der Abänderung, daß anstelle des α,ω-Dihydrogeneicosomethyldecasiloxans ein nach Arbeitsweise A hergestelltes Siloxan gemäß Formel (IX) eingesetzt wird, worin x jeweils die in Tabelle 4 angegebene Bedeutung hat. Es werden Poly(arylenvinylen-siloxane) mit den in Tabelle 4 angegebenen Ausbeuten, $M_w$, $M_w/M_n$, $P_w$, $T_g$, $T_i$ und d erhalten.

Tabelle 4

| Versuch | x | Ausbeute [%] | $M_w$ | $M_w/M_n$ | $P_w$ | $T_g$ [°C] | $T_i$ [°C] | d [nm] |
|---|---|---|---|---|---|---|---|---|
| 9.1 | 4 | 14 | 11 300 | 3,31 | 13 | 58 | 231 | 3,4 |
| 9.2 | 7 | 46 | 13 700 | 2,67 | 12 | -76/16 | 205 | 3,8 |
| 9.3 | 11 | 84 | 24 100 | 2,24 | 17 | -98/5 | 214 | 4,3 |
| 9.4 | 19 | 88 | 32 900 | 2,11 | 16 | -110 | 205 | - |

**Beispiel 10**

Die in Beispiel 1 beschriebene Verfahrensweise wird wiederholt mit der Abänderung, daß anstelle des $\alpha,\omega$-Dihydrogendodecamethylhexasiloxans ein nach Arbeitsweise B hergestelltes $\alpha,\omega$-Dihydrogendimethyl(poly)siloxan-Gemisch mit einer mittleren Kettenlänge von $x_m$ Siloxaneinheiten, wobei $x_m$ jeweils die in Tabelle 5 angegebene Bedeutung hat, eingesetzt wird. Es werden Poly(arylenvinylen-siloxane) mit den in Tabelle 5 angegebenen Ausbeuten, $M_w$, $M_w/M_n$, $P_w$, $T_g$, $T_i$ und d erhalten.

Tabelle 5

| Versuch | $x_m$ | Ausbeute [%] | $M_w$ | $M_w/M_n$ | $T_g$ [°C] | $T_i$ [°C] | d [nm] |
|---|---|---|---|---|---|---|---|
| 10.1 | 12 | 83 | 51 300 | 2,37 | -105/52 | 158 | 4,6 |
| 10.2 | 16 | 99 | 27 600 | 2,05 | -110/42 | 145 | 5,1 |
| 10.3 | 39 | 92 | 26 400 | 1,99 | -115/21 | ca.50 | - |
| 10.4 | 52 | 91 | 27 000 | 2,63 | -117/-28 | 40 | - |
| 10.5 | 68 | 100 | 63 900 | 2,01 | -116/-46 | 90 | |

## Patentansprüche

1. Polymere aus Einheiten der allgemeinen Formel

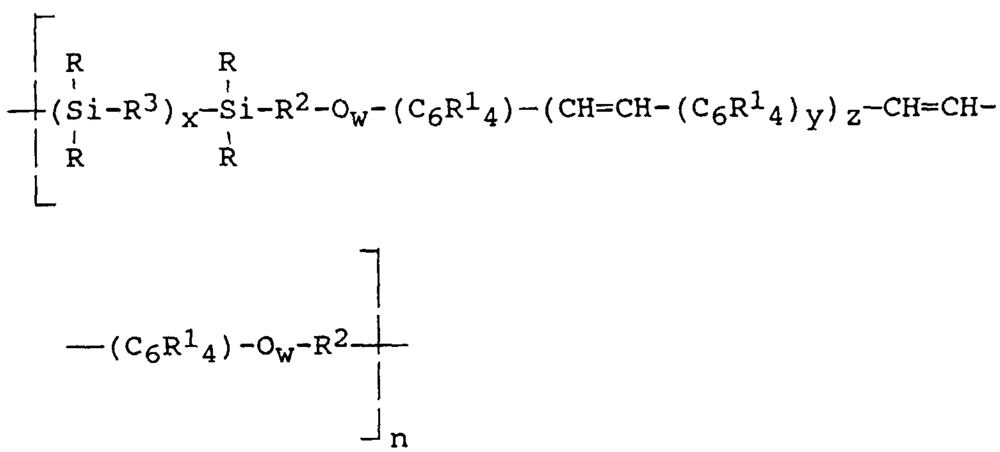

(I)

worin

R gleich oder verschieden sein kann und einwertige, gegebenenfalls substituierte, von aliphatischer Mehrfachbindung freie, SiC-gebundene organische Reste bedeutet,

$R^1$ gleich oder verschieden sein kann und Wasserstoffatom, Halogenatom, Nitrogruppe, Cyanogruppe oder einwertige, von aliphatischer Mehrfachbindung freie organische Reste, die gegebenenfalls substituiert sein können, bedeutet,

$R^2$ gleich oder verschieden sein kann und Alkylenreste, Cyanalkylenreste, Halogenalkylenreste und Halogenarylenreste bedeutet,

$R^3$ gleich oder verschieden sein kann und Sauerstoffatom oder zweiwertige, gegebenenfalls substituierte, von aliphatischer Mehrfachbindung freie SiC-gebundene organische Reste bedeutet,
n eine Zahl von 2 bis 500,
w 0 oder 1,
x eine Zahl von 1 bis 100,
y 1 oder 2 und
z eine Zahl von 1 bis 3

bedeutet, mit der Maßgabe, daß y gleich 1 ist, wenn z größer als 1 ist.

2. Polymere gemäß Anspruch 1, dadurch gekennzeichnet, daß $R^3$ gleich Sauerstoffatom ist.

3. Polymere gemäß einem oder mehreren der Ansprüche 1 bis 2, dadurch gekennzeichnet, daß die Vinylengruppen transkonfiguriert sind.

4. Verfahren zur Herstellung von Polymeren gemäß einem oder mehreren der Ansprüche 1 bis 3 durch Umsetzung von $\alpha,\omega$-Dialkenylarylenvinylen mit zwei Si-gebundene Wasserstoffatome aufweisender Organosiliciumverbindung in Gegenwart eines die Anlagerung von Si-gebundenem Wasserstoff an aliphatische Mehrfachbindung fördernden Katalysators.

5. Verfahren nach Anspruch 4, dadurch gekennzeichnet, daß als $\alpha,\omega$-Dialkenylarylenvinylen solche der Formel

$$R^4\text{-}O_w\text{-}(C_6R^1{}_4)\text{-}(CH{=}CH\text{-}(C_6R^1{}_4)_y)_z\text{-}CH{=}CH\text{-}(C_6R^1{}_4)\text{-}O_w\text{-}R^4 \quad \text{(II)}$$

eingesetzt werden, wobei
$R^1$, w, y und z eine der obengenannten Bedeutung haben und $R^4$ gleich oder verschieden sein kann und einen einwertigen, gegebenenfalls substituierten organischen Rest mit Kohlenstoff-Kohlenstoff-Doppelbindung bedeutet, mit der Maßgabe, daß y gleich 1 ist, wenn z größer als 1 ist.

6. Verfahren nach Anspruch 4 oder 5, dadurch gekennzeichnet, daß als zwei Si-gebundene Wasserstoffatome aufweisende Organosiliciumverbindung solche der Formel

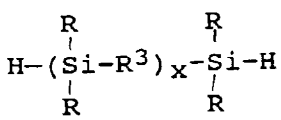

(VIII)

eingesetzt werden, wobei R, $R^3$ und x eine der oben dafür angegebene Bedeutung haben.

7. Verfahren nach einem oder mehreren der Ansprüche 4 bis 6, dadurch gekennzeichnet, daß $R^3$ gleich Sauerstoffatom ist.

8. Verwendung der Polymeren gemäß einem oder mehreren der Ansprüche 1 bis 3 oder herstellbar nach dem Verfahren gemäß einem oder mehreren der Ansprüche 4 bis 7 zur Herstellung von Duromeren.

9. Verwendung der Polymeren gemäß einem oder mehreren der Ansprüche 1 bis 3 oder herstellbar nach dem Verfahren gemäß einem oder mehreren der Ansprüche 4 bis 7 für Photoresistmaterialien.

## Claims

1. Polymers comprising units of the general formula

$$\left[ (\underset{R}{\overset{R}{|}}\!\!\!\!Si-R^3)_x-\underset{R}{\overset{R}{Si}}-R^2-O_w-(C_6R^1{}_4)-(CH{=}CH-(C_6R^1{}_4)_y)_z-CH{=}CH-(C_6R^1{}_4)-O_w-R^2 \right]_n \qquad (I)$$

in which

- R may be identical or different and denotes a monovalent, optionally substituted, SiC-bonded organic radical containing no aliphatic multiple bonds,
- $R^1$ may be identical or different and denotes a hydrogen atom, halogen atom, nitro group, cyano group or a monovalent, optionally substituted organic radical containing no aliphatic multiple bonds,
- $R^2$ may be identical or different and denotes an alkylene radical, a cyanoalkylene radical, a haloalkylene radical or a haloarylene radical,
- $R^3$ may be identical or different and denotes an oxygen atom or a divalent, optionally substituted, SiC-bonded organic radical containing no aliphatic multiple bonds,
- n is a number from 2 to 500,
- w is 0 or 1,
- x is a number from 1 to 100,
- y is 1 or 2, and
- z is a number from 1 to 3,

with the proviso that y is 1 if z is greater than 1.

**2.** Polymers according to Claim 1, characterized in that $R^3$ is an oxygen atom.

**3.** Polymers according to one or more of Claims 1 to 2, characterized in that the vinylene groups are trans-configured.

**4.** Process for the preparation of polymers according to one or more of Claims 1 to 3, by reacting an α,ω-dialkenylarylenevinylene with an organosilicon compound containing two Si-bonded hydrogen atoms, in the presence of a catalyst which promotes the addition reaction of Si-bonded hydrogen with an aliphatic multiple bond.

**5.** Process according to Claim 4, characterized in that the α,ω-dialkenylarylenevinylene has the formula

$$R^4\text{-}O_w\text{-}(C_6R^1{}_4)\text{-}(CH{=}CH\text{-}(C_6R^1{}_4)_y)_z\text{-}CH{=}CH\text{-}(C_6R^1{}_4)\text{-}O_w\text{-}R^4 \qquad (II)$$

where

$R^1$, w, y and z are as defined above, and
$R^4$ may be identical or different and denotes a monovalent, optionally substituted organic radical containing a carbon-carbon double bond,

with the proviso that y is 1 if z is greater than 1.

**6.** Process according to Claim 4 or 5, characterized in that the organosilicon compound containing two Si-bonded

hydrogen atoms is of the formula

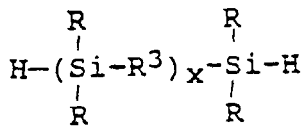

(VIII)

where R, $R^3$ and x are as defined above.

7. Process according to one or more of Claims 4 to 6, characterized in that $R^3$ is an oxygen atom.

8. Use of the polymers according to one or more of Claims 1 to 3, or which can be prepared by the process according to one or more of Claims 4 to 7, for the preparation of thermosets.

9. Use of the polymers according to one or more of Claims 1 to 3, or which can be prepared by the process according to one or more of Claims 4 to 7, for photoresist materials.

**Revendications**

1. Polymère constitué d'unités de formule générale

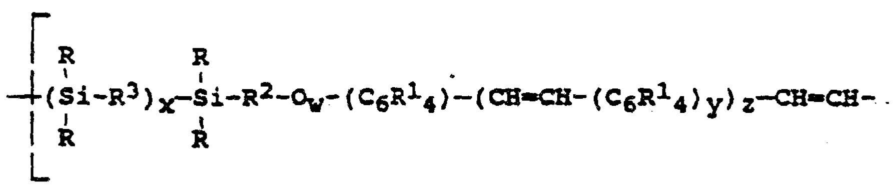

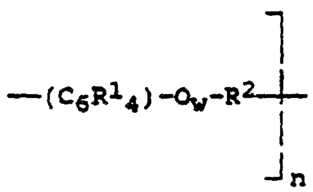

(I)

où

R peut être identique ou différent et représente un radical organique à liaison Si, monovalent, facultativement substitué, exempt de multiples liaisons aliphatiques,
$R^1$ peut être identique ou différent et représente un atome d'hydrogène, un atome d'halogène, un groupe nitro, un groupe cyano ou un radical organique monovalent, exempt de multiples liaisons aliphatiques, qui peut être facultativement substitué,
$R^2$ peut être identique ou différent et représente un radical alcoylène, un radical cyanoalcoylène, un radical halogénoalcoylène et un radical halogénoarylène,
$R^3$ peut être identique ou différent et représente un atome d'oxygène ou un radical organique à liaison Si, bivalent, facultativement substitué, exempt de multiples liaisons aliphatiques,
n représente un nombre de 2 à 500,
w représente 0 ou 1,
x représente un nombre de 1 à 100,
y représente 1 ou 2, et
z représente un nombre de 1 à 3

avec la condition que y est égal à 1 lorsque z est supérieur à 1.

**2.** Polymère suivant la revendication 1, caractérisé en ce que $R^3$ est égal à un atome d'oxygène.

**3.** Polymère suivant l'une ou plusieurs des revendications 1 et 2, caractérisé en ce que le groupe vinylène est de configuration trans.

**4.** Procédé de préparation des polymères suivant l'une ou plusieurs des revendications 1 à 3, par réaction de α,ω-dialcoylènearylènevinylènes avec un composé organosilicié comportant deux atomes d'hydrogène à liaison Si, en présence d'un catalyseur activant l'addition d'hydrogène à liaison Si sur une liaison multiple aliphatique.

**5.** Procédé suivant la revendication 4, caractérisé en ce que l'on utilise comme α,ω-dialcoylènearylène-vinylènes, ceux de formule

$$R^4\text{-}O_w\text{-}(C_6R^1{}_4)\text{-}(CH{=}CH\text{-}(C_6R^1{}_4)_y)_z\text{-}CH{=}CH\text{-}(C_6R^1{}_4)\text{-}O_w\text{-}R^4 \qquad \text{(II)}$$

où

$R^1$, w, y et z ont l'une des significations données ci-dessus, et
$R^4$ peut être identique ou différent et représente un radical organique monovalent, facultativement substitué avec une double liaison carbone-carbone,

avec la condition que y est égal à 1 lorsque z est supérieur à 1.

**6.** Procédé suivant la revendication 4 ou 5, caractérisé en ce que l'on utilise, comme composé organosilicié comportant deux atomes d'hydrogène à liaison Si, ceux de formule

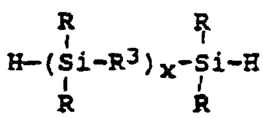

(VIII)

où

R, $R^3$ et x ont l'une des significations données ci-dessus.

**7.** Procédé suivant l'une ou plusieurs des revendications 4 à 6, caractérisé en ce que $R^3$ est égal à un atome d'oxygène.

**8.** Utilisation des polymères suivant l'une ou plusieurs des revendications 1 à 3 ou pouvant être préparés suivant l'une ou plusieurs des revendications 4 à 7, pour préparer des duroplastes.

**9.** Utilisation des polymères suivant l'une ou plusieurs des revendications 1 à 3 ou pouvant être préparés suivant l'une ou plusieurs des revendications 4 à 7, pour des matériaux photorésists.